# EUROPEAN PATENT SPECIFICATION

(11) **EP 4 561 304 B1**
(45) Date of publication and mention of the grant of the patent: **09.09.2026**
(21) Application number: 24207042.3
(22) Date of filing: 16.10.2024
(51) Int. Cl.: H10H 20/819, H10H 29/30, H10H 29/85

(54) **LIGHT-EMITTING ELEMENT AND DISPLAY DEVICE INCLUDING THE SAME**
LICHTEMITTIERENDES ELEMENT UND ANZEIGEVORRICHTUNG DAMIT
ÉLÉMENT ÉLECTROLUMINESCENT ET DISPOSITIF D'AFFICHAGE LE COMPRENANT

(30) Priority: 22.11.2023 KR 20230163238
(43) Date of publication of application: 28.05.2025
(73) Proprietor: LG Display Co., Ltd., Seoul 07336 (KR)
(72) Inventor: Yang, DongWon, 10845 Paju-si, Gyeonggi-do (KR); Kwon, Hyowon, 10845 Paju-si, Gyeonggi-do (KR); Shin, Yuseop, 10845 Paju-si, Gyeonggi-do (KR)
(74) Representative: Ter Meer Steinmeister & Partner

(56) References cited:
- EP-A1- 3 579 663
- EP-A1- 4 068 366
- KR-A- 20200 026 760
- US-A1- 2020 395 509
- US-A1- 2023 061 915
- US-A1- 2023 119 947
- US-A1- 2023 352 643

## Description

### BACKGROUND

### Field

The present specification relates to a light-emitting element and a display device including the same, and more particularly, to a light-emitting diode (LED) and a display device using the same.

### Description of Related Art

As display devices which are used for a monitor of a computer, a television, a cellular phone, or the like, there are an organic light emitting display (OLED) device which is a self-emitting device, a liquid crystal display (LCD) device which requires a separate light source, and the like.

An applicable range of the display device is diversified to personal digital assistants as well as monitors of computers and televisions and a display device with a large display area and a reduced volume and weight is being studied.

Further, recently, a display device including a light emitting diode (LED) is attracting attention as a next generation display device. Since the LED is formed of an inorganic material, rather than an organic material, reliability is excellent so that a lifespan thereof is longer than that of the liquid crystal display device or the organic light emitting display device. Further, the LED has a fast-lighting speed, excellent luminous efficiency, and a strong impact resistance so that a stability is excellent and an image having a high luminance can be displayed.

EP 3579663 A1 describes a display device that comprises: a substrate including a plurality of metal pads; and a green semiconductor light emitting element and a blue semiconductor light emitting element, which are electrically connected to the metal pads through self-assembly, wherein the green semiconductor light emitting element and the blue semiconductor light emitting element include identification parts having different shapes so as to be distinguishable from each other when connected to the sub strate.

US 2023/0352643 A1 describes a display device including a base portion, assembled electrodes extending along one direction on the base portion, a dielectric layer to cover the assembled electrodes, a partition wall portion on the dielectric layer while forming a plurality of cells, and a plurality of semiconductor light emitting diodes seated in the plurality of cells, respectively and to emit light of different colors.

EP 4068366 A1 describes a display device that includes a base part, a plurality of assembly electrodes disposed on the base part, and having a first electrode and a second electrode that generate an electric field when power is applied, a dielectric layer formed to cover the assembly electrodes and a plurality of semiconductor light emitting devices disposed on a surface of the dielectric layer, and a concave-convex structure formed on one surface of the semiconductor light emitting device facing the dielectric layer and one surface of the dielectric layer facing the semiconductor light emitting device, respectively.

US 2023/0061915 A1 describes a display device including a semiconductor light emitting device includes a first electrode and a second electrode spaced apart from each other on a predetermined substrate, an insulating layer disposed on the first and second electrodes, a first barrier wall disposed on the insulating layer and including a first assembling hole and a semiconductor light emitting device disposed in the first assembling hole of the first barrier wall.

### SUMMARY

An object to be achieved by the present invention is to provide a light-emitting element with an improved assembling rate and a display device including the same.

Another object to be achieved by the present invention is to provide a light-emitting element, which is manufactured by a reduced number of manufacturing processes, and a display device including the same.

Still another object to be achieved by the present invention is to provide a light-emitting element, which is capable of suppressing a color mixture defect, and a display device including the same.

Objects of the present invention are not limited to the above-mentioned objects, and other objects, which are not mentioned above, can be clearly understood by those skilled in the art from the following descriptions.

The object is solved by the features of the independent claim. Preferred embodiments are given in the dependent claims.

According to an example not forming part of the present invention, there is provided an assembling substrate in which a plurality of light-emitting elements are self-assembled. The assembling substrate comprises an assembly substrate; a plurality of first assembling electrodes on the assembly substrate; a plurality of second assembling electrodes on the assembly substrate, the plurality of second assembling electrodes alternating on the assembly substrate with the plurality of first assembling electrodes; and a plurality of concave-convex structures , wherein each of the plurality of concave-convex structures is between one of the plurality of first assembling electrodes and one of the plurality of second assembling electrodes.

According to the present invention, there is provided a light emitting element as defined by claim 1. The light emitting element comprises a first semiconductor layer including a concave pattern that extends from a lower surface of the first semiconductor layer towards an upper surface of the first semiconductor layer; a light-emitting layer on the first semiconductor layer; a second semiconductor layer on the light-emitting layer; a first electrode in contact with the first semiconductor layer; and a second electrode in contact with the second semiconductor layer.

According to one or more embodiments of the present invention, there is provided a display device as defined by claim 5. The display device comprises a substrate including a plurality of subpixels; a plurality of transistors on the substrate; and a light-emitting element in each of the plurality of subpixels on the substrate, wherein the light-emitting element of at least one of the plurality of subpixels includes a concave pattern that extends from a bottom surface of the light-emitting element towards a top surface of the light-emitting element, the bottom surface closer to the substrate than the top surface.

According to one or more embodiments of the present invention, there is provided a display device as defined by claim 8. The display device comprises an assembly substrate; a plurality of assembling electrodes on the assembly substrate, the plurality of assembling electrodes including a plurality of first assembling electrodes and a plurality of second assembling electrodes; an insulation layer on the plurality of assembling electrodes; a plurality of concave-convex structures on the insulation layer, each of the plurality of concave-convex structures overlapping an area between a first assembling electrode of the plurality of first assembling electrodes and a second assembling electrode of the plurality of second assembling electrodes, the plurality of concave-convex structures including a first concave-convex structure of a first size and a second concave-convex structure of a second size that is different from the first size; and a plurality of light emitting elements including: a first light emitting element that emits light of a first color and having a first concave pattern of a first concave size that extends from a first bottom surface of the first light emitting element towards a first top surface of the first light emitting element, the first bottom surface closer to the assembly substrate than the first top surface; and a second light emitting element that emits light of a second color and having a second concave pattern of a second concave size that is different from the first concave size, the second concave pattern extending from a second bottom surface of the second light emitting element towards a second top surface of the second light emitting element, the second bottom surface closer to the assembly substrate than the second top surface, wherein the first concave-convex structure is in the first concave pattern, and the second concave-convex structure is in the second concave pattern.In one or more embodiments, a concave-convex structure of the plurality of concave-convex structures may overlap a portion of a first assembling electrode of the plurality of first assembling electrodes and a portion of a second assembling electrode of the plurality of second assembling electrodes.

In one or more embodiments, the plurality of concave-convex structures may comprise a plurality of first concave-convex structures each having a first size, a plurality of second concave-convex structures each having a second size that is different than the first size, and a plurality of third concave-convex structures each having a third size that is different than the first size and the second size

In one or more embodiments, the plurality of first concave-convex structures, the plurality of second concave-convex structures, and the plurality of third concave-convex structures may have a substantially same planar shape.

In one or more embodiments, a first width of each of the plurality of first concave-convex structures may be less than a second width of each of the plurality of second concave-convex structures.

In one or more embodiments, the second width may be less than a third width of each of the plurality of third concave-convex structures.

In one or more embodiments, a first height of each of the plurality of first concave-convex structures may be greater than a second height of each of the plurality of second concave-convex structures.

In one or more embodiments, the second height may be greater than a third height of each of the plurality of third concave-convex structures.

In one or more embodiments, the plurality of first concave-convex structures may have a first planar shape.

In one or more embodiments, the plurality of second concave-convex structures may have a second planar shape that is different from the first planar shape.

In one or more embodiments, the plurality of third concave-convex structures may have a third planar shape that is different from the first planar shape and the second planar shape.

In one or more embodiments, the first electrode may be below the first semiconductor layer, and the first electrode covers a surface of the concave pattern.

In one or more embodiments, the light-emitting element may further comprise an encapsulation layer that covers a side surface of the first semiconductor layer.

In one or more embodiments, a first surface of the encapsulation layer may be in direct contact with the side surface of the first semiconductor layer.

In one or more embodiments, a second surface of the encapsulation layer may be in direct contact with the first electrode.

In one or more embodiments, the first electrode may extend from the lower surface of the first semiconductor layer.

The light-emitting element further comprises an auxiliary electrode between a side surface of the first semiconductor layer and a portion of the first electrode.

A first area in which the auxiliary electrode overlaps the side surface of the first semiconductor layer is larger than a second area in which a portion of the first electrode that extends from the bottom surface of the first semiconductor layer overlaps the side surface of the first semiconductor layer.

In one or more embodiments, the first electrode may be on the first semiconductor layer.

In one or more embodiments, the light-emitting element may further comprise an encapsulation layer disposed below the first semiconductor layer.

In one or more embodiments, the encapsulation layer may cover a surface of the concave pattern.

In one or more embodiments, the light-emitting element may further comprise a reflective layer below the first semiconductor layer.

In one or more embodiments, the reflective layer may cover a surface of the concave pattern.

In one or more embodiments, the display device may further comprise a first assembling electrode on a first portion of the bottom surface of the light-emitting element; a second assembling electrode on a second portion of the bottom surface of the light-emitting element and spaced apart from the first assembling electrode; and a concave-convex structure between the first assembling electrode and the second assembling electrode.

In one or more embodiments, the concave-convex structure may be in the concave pattern.

In one or more embodiments, the display device may further comprise a first connection electrode connecting the light-emitting element, the first assembling electrode, and the second assembling electrode.

In one or more embodiments, the display device may further comprise a reflective electrode below the bottom surface of the light-emitting element; and a bonding layer on the bottom surface of the light-emitting element, the bonding layer bonded to the light-emitting element.

In one or more embodiments, an interior of the concave pattern may be partially filled with the bonding layer.

In one or more embodiments, the concave pattern may include an airgap or an airgap (air) may be disposed in the concave pattern

In one or more embodiments, the first size of the first concave-convex structure may include a first width and a first height, and the second size of the second concave-convex structure includes a second width and a second height.

In one or more embodiments, the first width may be less than the second width, and the first height is greater than the second height.

In one or more embodiments, the plurality of concave-convex structures may further include a third concave-convex structure of a third size that is different from the first size and the second size.

In one or more embodiments, the plurality of light emitting elements may further include a third light emitting element that emits light of a third color and having a third concave pattern of a third concave size that is different from the first concave size and the second concave size.

In one or more embodiments, the third concave pattern may extend from a third bottom surface of the third light emitting element towards a third top surface of the third light emitting element.

In one or more embodiments, the third bottom surface may be closer to the substrate than the third top surface.

In one or more embodiments, the third concave-convex structure may be in the third concave pattern.

In one or more embodiments, the light of the first color may be red light, the light of the second color may be green light, and the light of the third color may be blue light.

In one or more embodiments, the first concave size of the first concave pattern may include a first width and a first height, and the second concave size of the second concave pattern includes a second width and a second height.

In one or more embodiments, the first width may be less than the second width.

In one or more embodiments, the first height may be greater than the second height.

In one or more embodiments, the first concave pattern may have a first planar shape.

In one or more embodiments, the second concave pattern may have a second planar shape that is different from the first planar shape.

In one or more embodiments, the first concave-convex structure may have the first planar shape.

In one or more embodiments, the second concave-convex structure may have the second planar shape.

Other detailed matters of the embodiments are included in the detailed description and the drawings.

According to the present disclosure, it is possible to inhibit the light-emitting element from being erroneously assembled during a process of assembling the light-emitting element to the panel.

According to the present disclosure, it is possible to simultaneously assemble the light-emitting elements with various colors, thereby reducing the number of manufacturing processes.

According to the present disclosure, it is possible to improve the luminous efficiency of the light-emitting element.

The effects according to the present disclosure are not limited to the contents exemplified above, and more various effects are included in the present disclosure.

### BRIEF DESCRIPTION OF THE DRAWINGS

The above and other embodiments, features and other advantages of the present disclosure will be more clearly understood from the following detailed description taken in conjunction with the accompanying drawings, in which:
FIG. 1 is a schematic cross-sectional view of a light-emitting element according to an embodiment of the present disclosure ;
FIGS. 2A to 2C are views for explaining a plurality of light-emitting elements according to the embodiment of the present disclosure;
FIGS. 3A to 3J are process diagrams for explaining a method of manufacturing the light-emitting element according to the embodiment of the present disclosure;
FIG. 4 is a schematic cross-sectional view of a light-emitting element according to another embodiment of the present disclosure;
FIG. 5 is a schematic configuration view of a display device according to an embodiment of the present disclosure;
FIG. 6 is a cross-sectional view of a pixel area of the display device according to the embodiment of the present disclosure;
FIGS. 7A and 7B are cross-sectional views for explaining a method of manufacturing the display device according to the embodiment of the present disclosure;
FIG. 8 is a cross-sectional view of a pixel area of a display device according to another embodiment of the present disclosure; and
FIGS. 9A to 9H are process diagrams for explaining a method of manufacturing the display device according to another embodiment of the present disclosure.

### DETAILED DESCRIPTION

Advantages and characteristics of the present disclosure and a method of achieving the advantages and characteristics will be clear by referring to embodiments described below in detail together with the accompanying drawings. However, the present disclosure is not limited to the embodiments disclosed herein but will be implemented in various forms. The embodiments are provided by way of example only so that those skilled in the art can fully understand the disclosures of the present disclosure and the scope of the present disclosure.

The shapes, sizes, ratios, angles, numbers, and the like illustrated in the accompanying drawings for describing the embodiments of the present disclosure are merely examples, and the present disclosure is not limited thereto. Like reference numerals generally denote like elements throughout the specification. Further, in the following description of the present disclosure, a detailed explanation of known related technologies may be omitted to avoid unnecessarily obscuring the subject matter of the present disclosure. The terms such as "including," "having," and "comprising" used herein are generally intended to allow other components to be added unless the terms are used with the term "only". Any references to singular may include plural unless expressly stated otherwise.

Components are interpreted to include an ordinary error range even if not expressly stated.

When the position relation between two parts is described using the terms such as "on", "above", "below", and "next", one or more parts may be positioned between the two parts unless the terms are used with the term "immediately" or "directly".

When an element or layer is disposed "on" another element or layer, another layer or another element may be interposed directly on the other element or therebetween.

Although the terms "first", "second", and the like are used for describing various components, these components are not confined by these terms. These terms are merely used for distinguishing one component from the other components. Therefore, a first component to be mentioned below may be a second component in a technical concept of the present disclosure.

Like reference numerals generally denote like elements throughout the specification.

A size and a thickness of each component illustrated in the drawing are illustrated for convenience of description, and the present disclosure is not limited to the size and the thickness of the component illustrated.

The features of various embodiments of the present disclosure can be partially or entirely adhered to or combined with each other and can be interlocked and operated in technically various ways, and the embodiments can be carried out independently of or in association with each other.

Hereinafter, embodiments of the present disclosure will be described in detail with reference to the drawings.

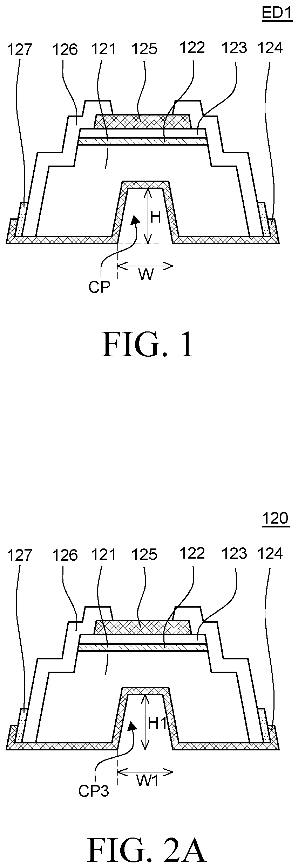

FIG. 1 is a schematic cross-sectional view of a light-emitting element of an embodiment. With reference to FIG. 1, a light-emitting element ED1 includes a first semiconductor layer 121, a light-emitting layer 122, a second semiconductor layer 123, a first electrode 124, a second electrode 125, an encapsulation layer 126, and an auxiliary electrode 127.

The light-emitting element ED1 may have various structures such as lateral, vertical, and flip-chip structures. The lateral light-emitting element includes the first and second electrodes horizontally disposed at two opposite sides of a light-emitting layer. The vertical light-emitting element includes the first and seconds electrodes disposed at upper and lower sides of the light-emitting layer. The flip-chip light-emitting element is substantially identical in structure to the lateral light-emitting element. The lateral light-emitting element has the first and second electrodes horizontally disposed at the upper side of the light-emitting layer, whereas the flip-chip light-emitting element has the first and second electrodes horizontally disposed at the lower side of the light-emitting layer. Hereinafter, the description is made on the assumption that the light-emitting element ED1 has the vertical structure. However, the types of the light-emitting elements ED1 are not limited thereto.

The first semiconductor layer 121 is disposed at a lower side of the light-emitting element ED1. The first semiconductor layer 121 may be a layer formed by doping a particular material with n-type and p-type impurities. For example, the first semiconductor layer 121 may be a layer formed by doping a material, such as gallium nitride (GaN), indium aluminum phosphide (InAlP), or gallium arsenic (GaAs), with n-type and p-type impurities. In this case, the p-type impurity may be magnesium, zinc (Zn), beryllium (Be), or the like. The n-type impurity may be silicon (Si), germanium, tin (Sn), or the like. However, the present disclosure is not limited thereto. In the present disclosure, the first semiconductor layer 121 is defined as an n-type semiconductor layer, i.e., a layer doped with n-type impurities. However, the present disclosure is not limited thereto.

The first semiconductor layer 121 includes a concave pattern CP.

The concave pattern CP is a portion disposed below the first semiconductor layer 121 and formed concavely in a direction in which the light-emitting layer 122 is disposed. Therefore, the concave pattern CP may be disposed below the light-emitting element ED1. A thickness of a portion of the first semiconductor layer 121 in which the concave pattern CP is disposed may be smaller than a thickness of a portion of the first semiconductor layer 121 disposed outside the concave pattern CP. The concave pattern is like a grove or dimple formed from the bottom of the first semiconductor layer 121.

A planar shape of the concave pattern CP may be a circular shape. However, the present disclosure is not limited thereto. In a cross-sectional shape of the concave pattern CP, the concave pattern CP may be inclined with respect to a bottom surface of the first semiconductor layer 121. For example, a width of the concave pattern CP may increase in a downward direction. However, the present disclosure is not limited thereto.

Meanwhile, FIG. 1 illustrates that one concave pattern CP is disposed in a cross-sectional view. However, the number of concave patterns CP is not limited thereto, and a plurality of concave patterns CP may be provided.

The light-emitting layer 122 and the second semiconductor layer 123 are disposed on the first semiconductor layer 121.

The light-emitting layer 122 may emit light by receiving positive holes and electrons from the first semiconductor layer 121 and the second semiconductor layer 123. The light-emitting layer 122 may be configured as a single layer or a multi-quantum well (MQW) structure. For example, the light-emitting layer 122 may be made of indium gallium nitride (InGaN), gallium nitride (GaN), or the like. However, the present disclosure is not limited thereto.

The second semiconductor layer 123 is disposed on the light-emitting layer 122. The second semiconductor layer 123 may be a layer formed by doping a particular material with n-type and p-type impurities. For example, the second semiconductor layer 123 may be a layer formed by doping a material, such as gallium nitride (GaN), indium aluminum phosphide (InAlP), or gallium arsenic (GaAs), with n-type and p-type impurities. Further, the p-type impurity may be magnesium(Mg), zinc (Zn), beryllium (Be), or the like. The n-type impurity may be silicon (Si), germanium (Ge), tin (Sn), or the like. However, the present disclosure is not limited thereto. In the present disclosure, the second semiconductor layer 123 is defined as a p-type semiconductor layer, i.e., a layer doped with p-type impurities. However, the present disclosure is not limited thereto.

Distances between the bottom surface of the first semiconductor layer 121 and top surfaces of the light-emitting layer 122 and the second semiconductor layer 123 based on the concave pattern CP may each be smaller than each of distances between the bottom surface of the first semiconductor layer 121 and the top surfaces of the light-emitting layer 122 and the second semiconductor layer 123 based on the portion disposed outside the concave pattern CP.

The first electrode 124 may be disposed on a lower portion and a part of a lateral portion of the first semiconductor layer 121. The first semiconductor layer 121 may be a semiconductor layer doped with n-type impurities, and the first electrode 124 may be a cathode.

The first electrode 124 is disposed on a bottom surface of the first semiconductor layer 121 and covers a surface of the concave pattern CP disposed on the lower portion of the first semiconductor layer 121. Therefore, the first electrode 124 may be disposed in a curved shape along the bottom surface of the first semiconductor layer 121. The first electrode 124 is fully covering the inner surface of the concave pattern CP.

In this case, the first electrode 124 may extend from the bottom surface of the first semiconductor layer 121 and be disposed to be spaced apart from a side surface of the first semiconductor layer 121 and surround a part of the side surface. For example, the first electrode 124 may be disposed to surround the side surface of the first semiconductor layer 121 disposed below the light-emitting layer 122. However, the present disclosure is not limited thereto. The first electrode 124 also extends upright to the a certain extent onto the outer side surfaces of the light-emitting element ED1.

The first electrode 124 may be made of an electrically conductive material, for example, an opaque conductive material such as titanium (Ti), gold (Au), silver (Ag), copper (Cu), or an alloy thereof. However, the present disclosure is not limited thereto. For example, the first electrode 124 may be made of a transparent conductive material such as indium tin oxide (ITO) or indium zinc oxide (IZO).

The second electrode 125 is disposed on the second semiconductor layer 123. The second electrode 125 may be disposed on a top surface of the second semiconductor layer 123. In this case, the second semiconductor layer 123 may be a semiconductor layer doped with p-type impurities, and the second electrode 125 may be an anode. The second electrode 125 may be made of an electrically conductive material, for example, a transparent conductive material such as indium tin oxide (ITO) or indium zinc oxide (IZO) or an opaque conductive material such as titanium (Ti), gold (Au), silver (Ag), copper (Cu), or an alloy thereof. However, the present disclosure is not limited thereto.

The encapsulation layer 126 is disposed to at least partially surround the first semiconductor layer 121, the light-emitting layer 122, the second semiconductor layer 123, and the second electrode 125. The encapsulation layer 126 may protect the first semiconductor layer 121, the light-emitting layer 122, and the second semiconductor layer 123. For example, the encapsulation layer 126 may cover a side surface of the first semiconductor layer 121, a side surface of the light-emitting layer 122, and a side surface of the second semiconductor layer 123. The encapsulation layer 126 may cover the entire side surface of the first semiconductor layer 121. However, the present disclosure is not limited thereto.

The encapsulation layer 126 may be disposed between the first semiconductor layer 121 and the first electrode 124. For example, one surface of the encapsulation layer 126 may adjoin the side surface of the first semiconductor layer 121, and the other surface of the encapsulation layer 126 may adjoin the first electrode 124 extending from the bottom surface of the first semiconductor layer 121 in upward direction. However, the present disclosure is not limited thereto

Meanwhile, the light-emitting element ED1 further includes the auxiliary electrode 127 connected to the first electrode 124. The auxiliary electrode 127 is disposed between the side surface of the first semiconductor layer 121 and the first electrode 124. In this case, an area in which the auxiliary electrode 127 and the side surface of the first semiconductor layer 121 overlap each other is larger than an area in which the first electrode 124 and the side surface of the first semiconductor layer 121 overlap each other. That is, a part of a lower side of the auxiliary electrode 127 adjoins the first electrode 124, and a part of an upper side of the auxiliary electrode 127 is exposed to the outside by the first electrode 124. In other words the auxiliary electrode 127 being arranged at the side surface of the light emitting element ED1 is longer than the extension of the first electrode 124 at the side surface

The light-emitting elements ED1 may include light-emitting elements configured to emit light beams with different colors. For example, the light-emitting elements ED1 include a red light-emitting element, a blue light-emitting element, and a green light-emitting element.

Hereinafter, the red light-emitting element, the blue light-emitting element, and the green light-emitting element will be described with reference to FIGS. 2A to 2C.

FIGS. 2A to 2C are views for explaining the plurality of light-emitting elements according to the embodiment of the present disclosure.

With reference to FIGS. 2A to 2C, the plurality of light-emitting elements ED1 include a red light-emitting element 120, a green light-emitting element 130, and a blue light-emitting element 140. The red light-emitting element 120, the green light-emitting element 130, and the blue light-emitting element 140 may be respectively referred to as a first light-emitting element, a second light-emitting element, and a third light-emitting element.

With reference to FIG. 2A, the red light-emitting element 120 includes the first semiconductor layer 121, a first light-emitting layer 122, the second semiconductor layer 123, the first electrode 124, the second electrode 125, the encapsulation layer 126, and the auxiliary electrode 127.

The red light-emitting element 120 includes a first concave pattern CP1 disposed below the first semiconductor layer 121.

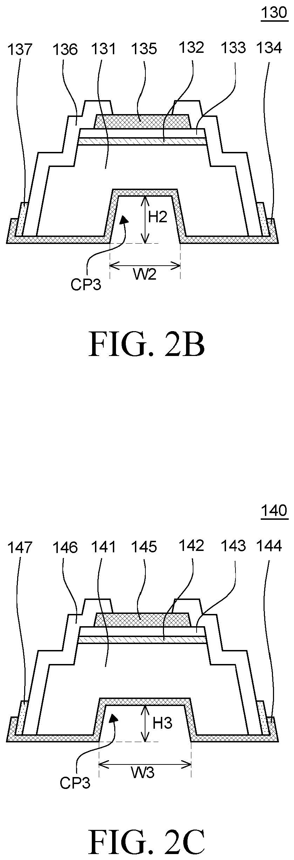

With reference to FIG. 2B, the green light-emitting element 130 includes a first semiconductor layer 131, a first light-emitting layer 132, a second semiconductor layer 133, a first electrode 134, a second electrode 135, an encapsulation layer 136, and an auxiliary electrode 137.

The green light-emitting element 130 includes a second concave pattern CP2 disposed below the first semiconductor layer 131.

With reference to FIG. 2C, the blue light-emitting element 140 includes a first semiconductor layer 141, a first light-emitting layer 142, a second semiconductor layer 143, a first electrode 144, a second electrode 145, an encapsulation layer 146, and an auxiliary electrode 147.

The blue light-emitting element 140 includes a third concave pattern CP3 disposed below the first semiconductor layer 141.

The red light-emitting element 120, the green light-emitting element 130, and the blue light-emitting element 140 may each include the first semiconductor layer 121, 131, or 141, the light-emitting layer 122, 132, or 142, the second semiconductor layer 123, 133, or 143, the first electrode 124, 134, or 144, the second electrode 125, 135, or 145, the encapsulation layer 126, 136, or 146, and the auxiliary electrode 127, 137, or 147 in common. However, the concave patterns CP may have different sizes (i.e., lengths and widths) and shapes.

For example, widths of the concave patterns CP may increase in the order of the first concave pattern CP1, the second concave pattern CP2, and the third concave pattern CP3, but heights of the concave patterns CP may decrease in the order of the first concave pattern CP1, the second concave pattern CP2, and the third concave pattern CP3.

A planar shape of the first concave pattern CP1 of the red light-emitting element 120 may be a circular shape. With reference to FIG. 2A, the first concave pattern CP1 of the red light-emitting element 120 may have a first width W1 and a first height H1.

A planar shape of the second concave pattern CP2 of the green light-emitting element 130 may be a circular shape. With reference to FIG. 2B, the second concave pattern CP2 may have a second width W2 and a second height H2. The second width W2 may be larger than the first width W1, and the second height H2 may be smaller than the first height H1.

A planar shape of the third concave pattern CP3 of the blue light-emitting element 140 may be a circular shape. With reference to FIG. 2C, the third concave pattern CP3 may have a third width W3 and a third height H3. The third width W3 may be larger than the second width W2, and the third height H3 may be smaller than the second height H2.

Meanwhile, the configuration has been described in which all the planar shapes of the first concave pattern CP1, the second concave pattern CP2, and the third concave pattern CP3 are circular shape. However, the present disclosure is not limited thereto. The planar shapes may be polygonal shapes. In addition, the planar shapes of the first concave pattern CP1, the second concave pattern CP2, and the third concave pattern CP3 may be identical to one another, but the first concave pattern CP1, the second concave pattern CP2, and the third concave pattern CP3 may have different widths and different heights. However, the present disclosure is not limited thereto. The planar shapes of the first concave pattern CP1, the second concave pattern CP2, and the third concave pattern CP3 may be different from one another. For example, the planar shape of the first concave pattern CP1 may be a circular shape, the planar shape of the second concave pattern CP2 may be an elliptical or polygonal shape, and the planar shape of the third concave pattern CP3 may be an elliptical or polygonal shape different from the planar shape of the second concave pattern CP2. However, the present disclosure is not limited thereto.

In addition, FIGS. 2A to 2C illustrate that an outer diameter of the red light-emitting element 120, an outer diameter of the green light-emitting element 130, and an outer diameter of the blue light-emitting element 140 are equal to one another. However, the present disclosure is not limited thereto. The outer diameter of the red light-emitting element 120, the outer diameter of the green light-emitting element 130, and the outer diameter of the blue light-emitting element 140 may be different from one another.

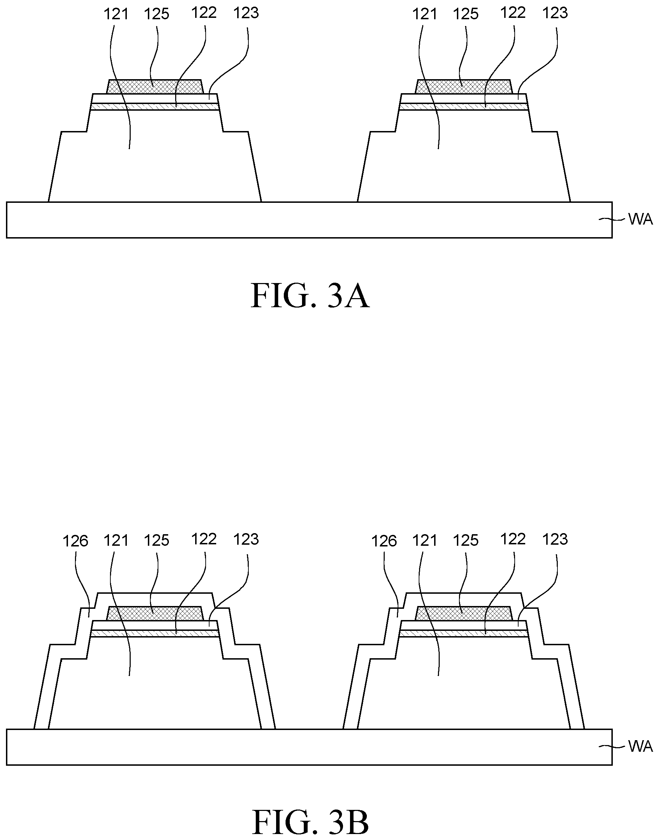

FIGS. 3A to 3J are process diagrams for explaining a method of manufacturing the light-emitting element according to the embodiment of the present disclosure. For convenience of description, the process of manufacturing the red light-emitting element 120 will be described with reference to FIGS. 3A to 3J. However, the present disclosure is not limited thereto. The process may be equally applied to the processes of manufacturing the green light-emitting element 130 and the blue light-emitting element 140.

With reference to FIG. 3A, the first semiconductor layer 121, the light-emitting layer 122, the second semiconductor layer 123, and the second electrode 125 are disposed on a wafer WA. A partial area of the first semiconductor layer 121, a partial area of the light-emitting layer 122, and a partial area of the second semiconductor layer 123 are in an etched state. The partial area of the first semiconductor layer 121, the partial area of the light-emitting layer 122, and the partial area of the second semiconductor layer 123 are in the etched state to separate the light-emitting element ED1 from the wafer WA, and the first semiconductor layer 121, the light-emitting layer 122, and the second semiconductor layer 123 in FIG. 3A constitute light-emitting structures on the wafer WA. In this case, the first semiconductor layer 121, the light-emitting layer 122, and the second semiconductor layer 123, which are etched in each unit of the light-emitting element ED1 are defined as light-emitting structures.

With reference to FIG. 3B, the encapsulation layer 126 is formed to cover top and side surfaces of the light-emitting structure. The encapsulation layer 126 covers the first semiconductor layer 121, the light-emitting layer 122, the second semiconductor layer 123, and the second electrode 125 exposed on the wafer WA.

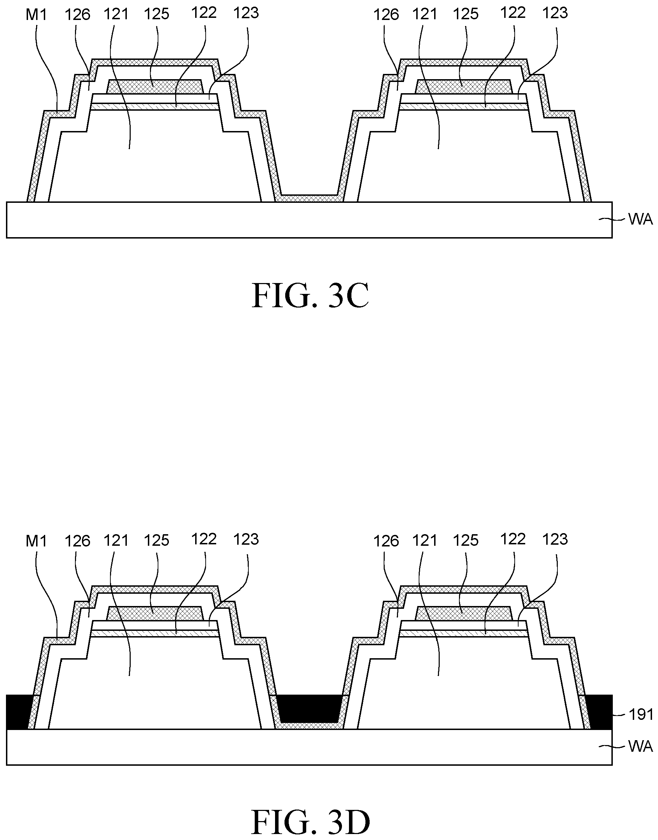

With reference to FIG. 3C, a first layer M1 is formed to cover the encapsulation layer 126 exposed on the wafer WA. In this case, the first layer M1 extends between the light-emitting structures and covers the top surface of the wafer WA exposed between the light-emitting structures.

With reference to FIG. 3D, a first cover layer 191 is formed on the light-emitting structure. The first cover layer 191 is formed to cover an area between the light-emitting structures. In this case, the first cover layer 191 is disposed only below the light-emitting layer 122. Therefore, the first cover layer 191 may cover a portion of the first layer M1 disposed below the light-emitting layer 122, and a portion of the first layer M1 disposed above the first cover layer 191 is exposed to the outside.

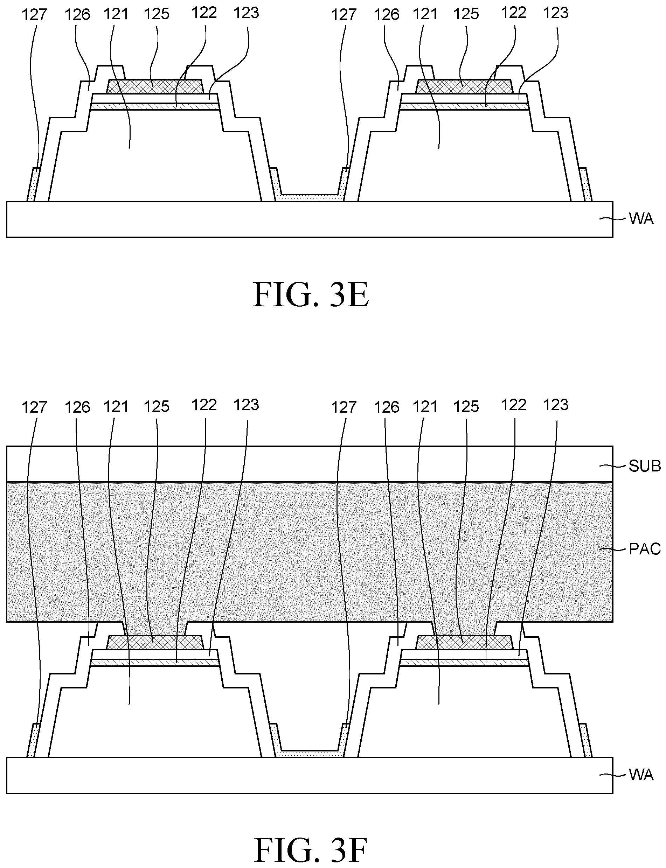

With reference to FIG. 3E, an etching process is performed. The first cover layer 191 serves as a mask, and the first layer M1 is etched in an area that is not covered by the first cover layer 191. Therefore, the auxiliary electrode 127, which covers the side surface of the first semiconductor layer 121, is formed by etching the first layer M1. Thereafter, the first cover layer 191 is removed.

With reference to FIG. 3F, the light-emitting structure, the second electrode 125, and the auxiliary electrode 127, which are disposed on the wafer WA, are attached to the dummy substrate SUB. An adhesive layer PAC may be formed on one surface of the dummy substrate SUB. The light-emitting structure disposed on the wafer WA, and the second electrode 125 and the auxiliary electrode 127, which cover the light-emitting structure, are bonded to the dummy substrate SUB by means of the adhesive layer PAC.

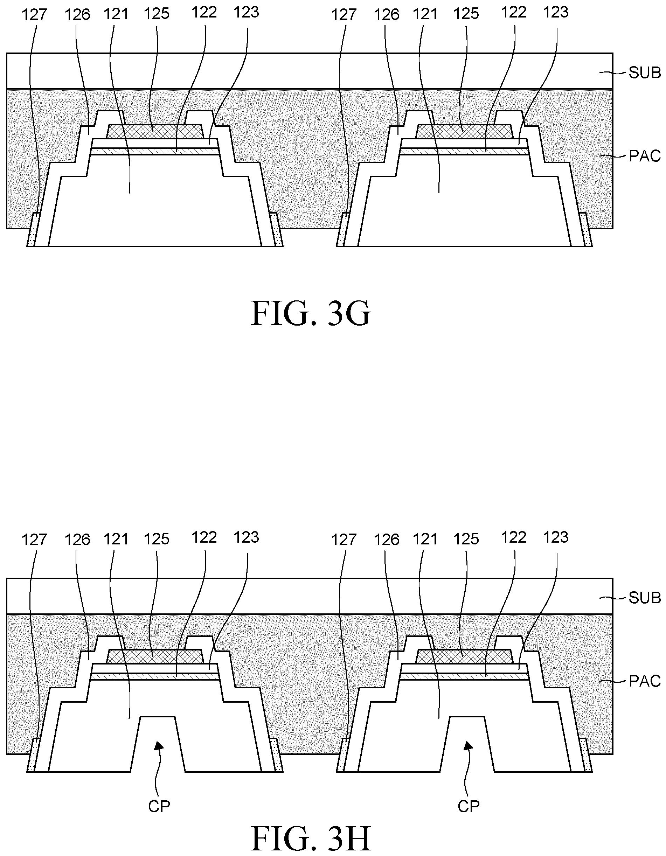

With reference to FIG. 3G, the wafer WA is pressed toward the dummy substrate SUB. Therefore, an area between the light-emitting structures is filled with the adhesive layer PAC of the dummy substrate SUB by pressure. In this case, the adhesive layer PAC may be additionally applied, and a part of a lower side of a partial area of the light-emitting structure may be exposed by performing an ashing process. Therefore, as illustrated in FIG. 3G, the adhesive layer PAC may surround a part of an upper side of the auxiliary electrode 127 and expose a part of a lower side of the auxiliary electrode 127. Thereafter, the wafer WA is removed, and the light-emitting structure remains at a side of the dummy substrate SUB.

With reference to FIG. 3H, the concave pattern CP is formed on the bottom surface of the first semiconductor layer 121 exposed from the dummy substrate SUB. The concave pattern CP is formed by etching a part of the first semiconductor layer 121 exposed by the adhesive layer PAC. The concave pattern CP is formed as the first semiconductor layer 121 is etched in the direction of the dummy substrate SUB by means of the etching process.

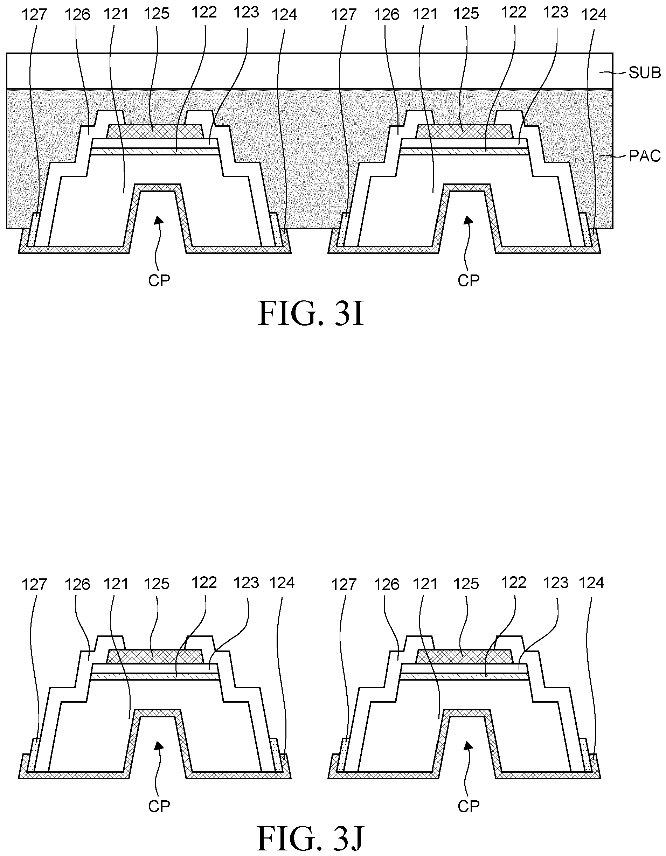

With reference to FIG. 3I, the first electrode 124 is formed on the bottom surface of the first semiconductor layer 121 exposed from the dummy substrate SUB. The first electrode 124 covers the concave pattern CP. In this case, the first electrode 124 covers the auxiliary electrode 127 and the side surface of the first semiconductor layer 121 exposed by the adhesive layer PAC of the dummy substrate SUB.

With reference to FIG. 3J, the dummy substrate SUB and the adhesive layer PAC are removed. Therefore, the light-emitting structure, the first electrode 124, the second electrode 125, the encapsulation layer 126, and the auxiliary electrode 127, which have been attached to the adhesive layer PAC, are separated, such that the light-emitting element ED1 is formed.

In the case of the light-emitting elements for assembly, the plurality of light-emitting elements is immersed in a fluid and self-assembled. In this case, the plurality of light-emitting elements is assembled by an electric field applied to assembling electrodes. However, the same electric field is applied to the assembling electrodes, which makes it difficult to distinguish and assemble the plurality of light-emitting elements. For example, in case that the plurality of light-emitting elements, which emits light beams with different colors, is immersed in the fluid and self-assembled, there may occur a problem in that the light-emitting element is not assembled at a desired position, such as a problem in which the green light-emitting element or the blue light-emitting element is assembled in the red subpixel area. In case that the above-mentioned problem occurs, a color mixture defect may occur, and an assembling rate of the plurality of light-emitting elements decreases, which may degrade a yield of the display device.

Therefore, in the light-emitting elements ED1 according to the embodiment of the present disclosure, the concave patterns CP may be disposed at the lower sides of the light-emitting elements ED1 to distinguish the light-emitting elements ED1. For example, the first concave pattern CP1 of the red light-emitting element 120, the second concave pattern CP2 of the green light-emitting element 130, and the third concave pattern CP3 of the blue light-emitting element 140 may have different sizes. The red light-emitting element 120, the green light-emitting element 130, and the blue light-emitting element 140 may be self-assembled while corresponding to a substrate having concave-convex structures corresponding to the sizes of the concave patterns CP. Specifically, a first concave-convex structure, a second concave-convex structure, and a third concave-convex structure may be disposed between assembling electrodes 160, and the first concave-convex structure, the second concave-convex structure, and the third concave-convex structure are disposed to correspond to the sizes of the first concave pattern CP1, the second concave pattern CP2, and the third concave pattern CP3, such that the light-emitting elements, which emit light beams with particular colors, may be self-assembled in subpixels SP that emit light beams with the corresponding colors. Therefore, in the light-emitting element ED1 according to the embodiment of the present disclosure, the assembling rate of the light-emitting element ED1 may be improved.

Meanwhile, the plurality of light-emitting elements ED1 may have the same outer diameter in case that the first concave pattern CP1, the second concave pattern CP2, and the third concave pattern CP3 are disposed to have different sizes and the red light-emitting element 120, the green light-emitting element 130, and the blue light-emitting element 140 are self-assembled at positions respectively corresponding to the plurality of subpixels SP. In the related art, the plurality of light-emitting elements is formed to have different outer diameters and self-assembled. For example, a planar shape of the red light-emitting element 120 is set to a circular shape, a planar shape of the green light-emitting element 130 is set to an elliptical shape, and a planar shape of the blue light-emitting element 140 is set to an elliptical shape different from the planar shape of the green light-emitting element 130, such that the light-emitting elements having the particular shapes may be assembled in the subpixels that emit light beams with particular colors. In contrast, in the light-emitting elements ED1 according to the embodiment of the present disclosure, the assembling rate of the light-emitting elements ED1 may be improved by adjusting the sizes of the concave patterns CP even though the plurality of light-emitting elements ED1 has the same outer diameters. Therefore, the light-emitting elements ED1, which emit light beams with different colors, may be manufactured by the same masking process, which may reduce the number of processes of manufacturing the light-emitting elements ED1 and reduce costs.

In addition, in the light-emitting element ED1 according to the embodiment of the present disclosure, the concave pattern CP is disposed below the first semiconductor layer 121, 131, or 141. Therefore, in the area in which the concave pattern CP is disposed, a thickness of the first semiconductor layer 121, 131, or 141 may decrease. In the concave pattern CP, an interval between the first electrode 124, 134, or 144 and the second electrode 125, 135, or 145 may decrease. Therefore, the luminous efficiency of the light-emitting element ED1 may be improved.

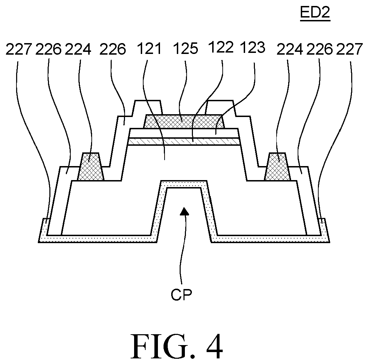

FIG. 4 is a schematic cross-sectional view of a light-emitting element according to another embodiment of the present disclosure. A light-emitting element ED2 in FIG. 4 is substantially identical in configuration to the light-emitting element ED1 in FIGS. 1 to 3G, except that a protective layer 227 is added, a first electrode 224 and an encapsulation layer 226 are different from those of the light-emitting element ED1, and the auxiliary electrode 127 is not disposed. Therefore, a repeated description will be omitted.

With reference to FIG. 4, the first electrode 224 is disposed on the first semiconductor layer 121. The first electrode 224 is disposed on the first semiconductor layer 121 protruding to the outside of the light-emitting layer 122 and the second semiconductor layer 123.

The encapsulation layer 226 is disposed to at least partially surround the first semiconductor layer 121, the light-emitting layer 122, the second semiconductor layer 123, and the second electrode 125. The encapsulation layer 226 may cover the side surface of the first semiconductor layer 121, the side surface of the light-emitting layer 122, the side surface of the second semiconductor layer 123, and the top surface of the second semiconductor layer 123 in an area in which the first electrode 224 and the second electrode 125 are excluded. Meanwhile, the encapsulation layer 226 may cover a part of the first electrode 224 and a part of the top surface of the second electrode 125. However, the present disclosure is not limited thereto.

The protective layer 227 is disposed below the light-emitting element ED2. The protective layer 227 covers the surface of the concave pattern CP disposed below the first semiconductor layer 121. Therefore, the protective layer 227 may be disposed in a curved shape along the bottom surface of the first semiconductor layer 121.

In this case, the protective layer 227 may extend from the bottom surface of the first semiconductor layer 121 and be disposed to surround a part of the side surface of the first semiconductor layer 121. For example, the protective layer 227 may be disposed to surround the encapsulation layer 226 and the side surface of the first semiconductor layer 121 disposed below the light-emitting layer 122. However, the present disclosure is not limited thereto.

The protective layer 227 may inhibit the plurality of light-emitting elements ED2 from agglomerating. The light-emitting element ED2 is made of a semiconductor doped with impurities and has a polarity. In this case, in case that the surface of the light-emitting element ED2 is exposed without being covered, a mutual cohesive force is generated between the light-emitting elements ED2, and the light-emitting elements ED2 agglomerate. Therefore, the protective layer 227 may cover the bottom surface of the first semiconductor layer 121 of the light-emitting element ED2, thereby inhibiting the plurality of light-emitting elements ED1 from agglomerating.

The protective layer 227 may be made of a material excellent in reflectivity. Therefore, the protective layer 227 may be a reflective layer. The protective layer 227 may be disposed below the first semiconductor layer 121, cover the surface of the concave pattern CP, and reflect the light emitted from the light-emitting element ED2, toward the upper side of the light-emitting element ED2. For example, the protective layer 227 may be made by using an opaque conductive layer made of silver (Ag), aluminum (Al), molybdenum (Mo), titanium (Ti), or an alloy thereof, together with a transparent conductive layer made of indium tin oxide (ITO). However, the structure of the protective layer 227 is not limited thereto.

Meanwhile, like the encapsulation layer 226, the protective layer 227 may be made of an insulating material and protect the first semiconductor layer 131. For example, the protective layer 227 may be made of the same material as the encapsulation layer 226. Meanwhile, in case that the protective layer 227 is made of the same material as the encapsulation layer 226, the protective layer 227 and the encapsulation layer 226 may be integrally implemented and cover the top and side surfaces of the light-emitting element ED2 and the surface of the concave pattern CP disposed below the first semiconductor layer 121. However, the present disclosure is not limited thereto.

In the light-emitting elements ED2 according to another embodiment of the present disclosure, the concave patterns CP having different sizes are disposed at the lower sides of the light-emitting elements ED2, such that the light-emitting elements ED2 may be distinguished, which may suppress a color mixture defect and improve the assembling rate of the light-emitting element.

In addition, in the light-emitting elements ED2 according to another embodiment of the present disclosure, the light-emitting elements ED2, which emit light beams with different colors, may be distinguished only by means of the sizes of the plurality of concave patterns CP. Therefore, the light-emitting elements ED2, which emit light beams with different colors, may have the same external shape, and the light-emitting elements ED2 may be manufactured by the same process, which may reduce the number of manufacturing processes and the manufacturing costs.

Meanwhile, the light-emitting elements ED2 may include light-emitting elements configured to emit light beams with different colors. For example, the light-emitting elements ED2 include a red light-emitting element, a blue light-emitting element, and a green light-emitting element.

The red light-emitting element, the green light-emitting element, and the blue light-emitting element may include in common the first semiconductor layer, the light-emitting layer, the second semiconductor layer, the first electrode, the second electrode, the encapsulation layer, and the protective layer, but have the concave patterns CP different in sizes and shapes.

For example, the red light-emitting element, the green light-emitting element, and the blue light-emitting element may respectively include the first concave pattern, the second concave pattern, and the third concave pattern. The widths of the concave patterns CP may increase in the order of the first concave pattern, the second concave pattern, and the third concave pattern, whereas the heights of the concave patterns CP may decrease in the order of the first concave pattern, the second concave pattern, and the third concave pattern.

In addition, in the light-emitting element ED2 according to the embodiment of the present disclosure, the thickness of the first semiconductor layer 121 in the area, in which the concave pattern CP is disposed, may decrease, which may improve the luminous efficiency of the light-emitting element ED2.

The light-emitting element ED2 according to another embodiment of the present disclosure is implemented as the lateral structure in which the first electrode 224 is disposed on the first semiconductor layer 121. Therefore, the light-emitting element ED2 may be connected to the display panel without performing bonding metal forming and thermal compression processes performed to connect the vertical light-emitting element to the display panel. Therefore, in the light-emitting element ED2 according to another embodiment of the present disclosure, a process optimization may be implemented because the light-emitting element ED2 may be connected to the display panel without performing the bonding metal forming process and the thermal compression process.

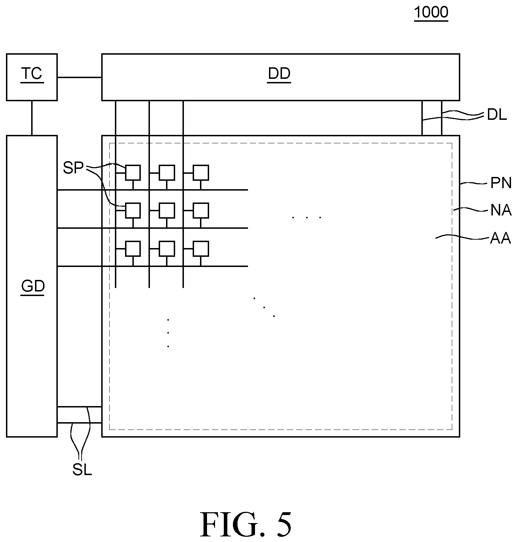

FIG. 5 is a schematic configuration view of a display device according to an embodiment of the present disclosure. For convenience of description, FIG. 5 illustrates only a display panel PN, a gate drive part GD, a data drive part DD, and a timing controller TC among various constituent elements of a display device 1000.

With reference to FIG. 5, the display device 1000 includes the display panel PN including the plurality of subpixels SP, the gate drive part GD configured to supply various types of signals to the display panel PN, and the timing controller TC configured to control the data drive part DD, the gate drive part GD, and the data drive part DD.

The gate drive part GD supplies a plurality of scan signals to a plurality of scan lines SL in response to a plurality of gate control signals provided from the timing controller TC. FIG. 5 illustrates that the single gate drive part GD is disposed to be spaced apart from one side of the display panel PN. However, the number and arrangement of the gate drive part GD are not limited thereto.

The data drive part DD converts image data, which are inputted from the timing controller TC, into a data voltage by using a reference gamma voltage in response to a plurality of data control signals provided from the timing controller TC. The data drive part DD may supply the converted data voltage to a plurality of data lines DL.

The timing controller TC aligns image data, which are inputted from the outside, and supplies the image data to the data drive part DD. The timing controller TC may generate the gate control signals and the data control signals by using synchronizing signals, i.e., dot clock signals, data enable signals, and horizontal/vertical synchronizing signals inputted from the outside. Further, the timing controller TC may control the gate drive part GD and the data drive part DD by supplying the generated gate control signals and data control signals to the gate drive part GD and the data drive part DD.

The display panel PN is configured to display images to a user and includes the plurality of subpixels SP.

The display panel PN may have a display area AA, and a non-display area NA configured to surround the display area AA.

The display area AA is an area of the display device 1000 in which images are displayed. The display area AA may include a plurality of subpixels SP constituting a plurality of pixels, and a circuit configured to operate the plurality of subpixels SP. The plurality of subpixels SP is minimum units that constitute the display area AA. The n subpixels SP may constitute a single pixel. A light-emitting element, a thin-film transistor for operating the light-emitting element, and the like may be disposed in each of the plurality of subpixels SP. The plurality of light-emitting elements may be differently defined depending on the type of the display panel PN. For example, in case that the display panel PN is an inorganic light-emitting display panel, the light-emitting element may be a light-emitting diode (LED) or a micro light-emitting diode (micro-LED).

A plurality of lines for transmitting various types of signals to the plurality of subpixels SP is disposed in the display area AA. For example, the plurality of lines may include the plurality of data lines DL for supplying data voltages to the plurality of subpixels SP, and the plurality of scan lines SL for supplying scan signals to the plurality of subpixels SP. The plurality of scan lines SL may extend in one direction in the display area AA and be connected to the plurality of subpixels SP. The plurality of data lines DL may extend in a direction different from one direction in the display area AA and be connected to the plurality of subpixels SP. In addition, a low-potential power line, a high-potential power line, and the like may be further disposed in the display area AA. However, the present disclosure is not limited thereto.

The non-display area NA may be defined as an area in which no image is displayed, i.e., an area extending from the display area AA. The non-display area NA may include link lines and pad electrodes for transmitting signals to the subpixels SP in the display area AA. Alternatively, the non-display area NA may include drive ICs such as gate drivers IC and data drivers IC.

However, the non-display area NA may be positioned on a rear surface of the display panel PN, i.e., a surface on which the subpixel SP is not present. Alternatively, the non-display area NA may be excluded. However, the present disclosure is not limited to the configuration illustrated in the drawings.

Meanwhile, the drive parts such as the gate drive part GD, the data drive part DD, and the timing controller TC may be connected to the display panel PN in various ways. For example, the gate drive part GD may be mounted in the non-display area NA by a gate-in-panel (GIP) method or mounted between the plurality of subpixels SP by a gate-in-active area (GIA) method in the display area AA. For example, the data drive part DD and the timing controller TC may be formed on a separate flexible film and the printed circuit board PCB. The data drive part DD and the timing controller TC may be electrically connected to the display panel PN by bonding the flexible film and the printed circuit board PCB to the pad electrode formed in the non-display area NA of the display panel PN.

In case that the gate drive part GD is mounted by the GIP method and the data drive part DD and the timing controller TC transmit signals to the display panel PN through the pad electrode in the non-display area NA, it is necessary to ensure an area of the non-display area NA at a predetermined level or higher in order to dispose the gate drive part GD and the pad electrode, which may increase a bezel.

Alternatively, in case that the gate drive part GD is mounted in the display area AA by the GIA method and a side line, which connects a signal line on a front surface of the display panel PN to the pad electrode on the rear surface of the display panel PN, is formed to bond the flexible film and the printed circuit board to the rear surface of the display panel PN, it is possible to minimize the non-display area NA on the front surface of the display panel PN. That is, in case that the gate drive part GD, the data drive part DD, and the timing controller TC are connected to the display panel PN by the above-mentioned method, a zero bezel in which the bezel is not substantially present may be implemented.

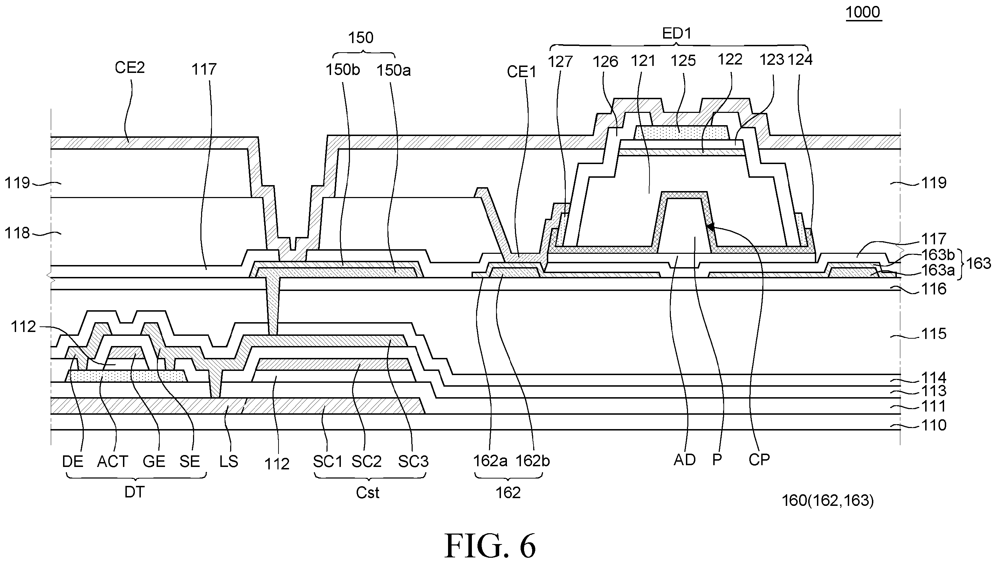

FIG. 6 is a cross-sectional view of a pixel area of the display device according to the embodiment of the present disclosure.

With reference to FIG. 6, the display device 1000 includes a substrate 110, a light-blocking layer LS, a buffer layer 111, a gate insulation layer 112, a first interlayer insulation layer 113, a first passivation layer 114, a first planarization layer 115, a second passivation layer 116, a third passivation layer 117, a second planarization layer 118, a third planarization layer 119, the assembling electrode 160, a connection electrode 150, the light-emitting element ED1, a concave-convex structure P, and a storage capacitor Cst.

With reference to FIG. 6, the display device 1000 includes the substrate 110. The substrate 110 may be a substrate, i.e., an insulation substrate configured to support the constituent elements disposed at an upper side of the display device 1000. The plurality of subpixels SP may be formed on the substrate 110 so that images may be displayed. For example, the substrate 110 may be made of glass, resin, or the like. In addition, the substrate 110 may include polymer or plastic. In several embodiments, the substrate 110 may be made of a plastic material having flexibility.

The plurality of subpixels SP may be disposed in a plurality of rows and a plurality of columns on the substrate 110. The plurality of subpixels SP may each include the light-emitting element ED1 and a pixel circuit and independently emit light.

The plurality of subpixels SP may include a first subpixel, a second subpixel, and a third subpixel that emit light beams with different colors. For example, the first subpixel may be a red subpixel, the second subpixel may be a green subpixel, and the third subpixel may be a blue subpixel. However, the present disclosure is not limited thereto.

A first light-emitting element may be disposed on the first subpixel, a second light-emitting element may be disposed on the second subpixel, and a third light-emitting element may be disposed on the third subpixel. For example, the first light-emitting element may be a red light-emitting element, the second light-emitting element may be a green light-emitting element, and the third light-emitting element may be a blue light-emitting element. However, the present disclosure is not limited thereto.

A plurality of lines for transmitting various types of signals to the plurality of subpixels SP is disposed on the substrate 110. For example, the plurality of data lines DL, a plurality of high-potential power lines VDD, and a plurality of low-potential power lines, which extend in a column direction, may be disposed on the fsubstrate 110. For example, a plurality of light-emitting control signal lines, a plurality of auxiliary high-potential power lines, a plurality of auxiliary low-potential power lines, and a plurality of scan lines, which extend in a row direction, may be disposed on the substrate 110. Further, the high-potential power line VDD, which extends in the column direction, and the auxiliary high-potential power line, which extends in the row direction, may be electrically connected to each other through a contact hole. In this case, the light-emitting control signal lines transmit light-emitting control signals to the pixel circuits of the plurality of subpixels SP to control light-emitting timings of the plurality of subpixels SP.

The pixel circuit for operating the light-emitting element ED1 is disposed in each of the plurality of subpixels SP on the substrate 110. The pixel circuit may include a plurality of thin-film transistors and a plurality of capacitors. For convenience of description, FIG. 6 illustrates only a driving transistor DT and the storage capacitor Cst among the components of the pixel circuit. However, the pixel circuit may further include a switching transistor, a sensing transistor, a light emission control transistor, and the like. However, the present disclosure is not limited thereto.

The light-blocking layer LS is provided on each of the plurality of subpixels SP and disposed on the substrate 110. The light-blocking layer LS may block light, which enters the transistor from a lower side of the substrate 110, and minimize or at least reduce a leakage current. For example, the light-blocking layer LS may block light entering an active layer ACT.

A first capacitor electrode SC1 is provided on each of the plurality of subpixels SP and disposed on the substrate 110. The first capacitor electrode SC1, together with other capacitor electrodes, may constitute the storage capacitor Cst. The first capacitor electrode SC1 may be integrated with the light-blocking layer LS.

The buffer layer 111 is disposed on the light-blocking layer LS and the first capacitor electrode SC1. The buffer layer 111 may reduce the penetration of moisture or impurities through the substrate 110. For example, the buffer layer 111 may be configured as a single layer or multilayer made of silicon oxide (SiOx) or silicon nitride (SiNx). However, the present disclosure is not limited thereto. However, the buffer layer 111 may be excluded in accordance with the type of substrate 110 or the type of transistor. However, the present disclosure is not limited thereto.

The driving transistor DT is disposed on the buffer layer 111 in each of the plurality of subpixels SP. The driving transistor DT is a transistor that supplies a drive current to the light-emitting element ED1. The driving transistor DT may be turned on and control the drive current flowing to the light-emitting element ED1.

The driving transistor DT includes the active layer ACT, the gate electrode GE, the source electrode SE, and the drain electrode DE.

The active layer ACT is disposed on the buffer layer 111. The active layer ACT may be made of a semiconductor material such as an oxide semiconductor, amorphous silicon, or polysilicon. However, the present disclosure is not limited thereto.

The gate insulation layer 112 is disposed on the active layer ACT. The gate insulation layer 112 is an insulation layer for insulating the active layer ACT and the gate electrode GE. The gate insulation layer 112 may be configured as a single layer or multilayer made of silicon oxide (SiOx) or silicon nitride (SiNx). However, the present disclosure is not limited thereto. Meanwhile, FIG. 6 illustrates that the gate insulation layer 112 is disposed only in an area that overlaps the gate electrode GE and a second capacitor electrode SC2. However, the present disclosure is not limited thereto.

The gate electrode GE is disposed on the gate insulation layer 112. The gate electrode GE may be made of an electrically conductive material, for example, copper (Cu), aluminum (Al), molybdenum (Mo), nickel (Ni), titanium (Ti), chromium (Cr), or an alloy thereof. However, the present disclosure is not limited thereto.

The first interlayer insulation layer 113 is disposed on the gate electrode GE. Contact holes, through which the source electrode SE and the drain electrode DE are connected to the active layer ACT, are formed in the first interlayer insulation layer 113. The first interlayer insulation layer 113 is an insulation layer for protecting components disposed below the first interlayer insulation layer 113. The first interlayer insulation layer 113 may be configured as a single layer or multilayer made of silicon oxide (SiOx) or silicon nitride (SiNx). However, the present disclosure is not limited thereto.

The source electrode SE and the drain electrode DE are disposed on the first interlayer insulation layer 113 and electrically connected to the active layer ACT. The drain electrode DE may be electrically connected to the active layer ACT and the high-potential power line, and the source electrode SE may be electrically connected to the active layer ACT and the light-emitting element ED1. The source electrode SE and the drain electrode DE may each be made of an electrically conductive material, for example, copper (Cu), aluminum (Al), molybdenum (Mo), nickel (Ni), titanium (Ti), chromium (Cr), or an alloy thereof. However, the present disclosure is not limited thereto.

The second capacitor electrode SC2 is disposed on the gate insulation layer 112. The second capacitor electrode SC2 may be one of the electrodes that constitute the storage capacitor Cst. The second capacitor electrode SC2 may be disposed to overlap the first capacitor electrode SC1. Although not illustrated in the drawings, the second capacitor electrode SC2 may be integrated with the gate electrode GE of the driving transistor DT and electrically connected to the gate electrode GE. However, the present disclosure is not limited thereto. The first capacitor electrode SC1 and the second capacitor electrode SC2 may be disposed to be spaced apart from each other with the buffer layer 111 and the gate insulation layer 112 interposed therebetween.

A third capacitor electrode SC3 is disposed on the first interlayer insulation layer 113. The third capacitor electrode SC3 may be an electrode that constitutes the storage capacitor Cst. The third capacitor electrode SC3 may be disposed to overlap the first capacitor electrode SC1 and the second capacitor electrode SC2. The third capacitor electrode SC3 may be integrated with the source electrode SE of the driving transistor DT and electrically connected to the source electrode SE. Further, the source electrode SE may also be electrically connected to the first capacitor electrode SC1 through contact holes formed in the first interlayer insulation layer 113 and the buffer layer 111. Therefore, the first capacitor electrode SC1 and the third capacitor electrode SC3 may be electrically connected to the source electrode SE of the driving transistor DT.

The storage capacitor Cst may store a potential difference between the gate electrode GE and the source electrode SE of the driving transistor DT while the light-emitting element ED1 emits light, such that a constant current may be supplied to the light-emitting element ED1. The storage capacitor Cst includes the first capacitor electrode SC1 formed on the substrate 110 and connected to the source electrode SE, the second capacitor electrode SC2 formed on the buffer layer 111 and the gate insulation layer 112, and the third capacitor electrode SC3 formed on the first interlayer insulation layer 113 and connected to a second source electrode SE2. The storage capacitor Cst may store a voltage between the gate electrode GE and the source electrode SE of the driving transistor DT.

The first passivation layer 114 is disposed on the driving transistor DT and the storage capacitor Cst. The first passivation layer 114 may be an insulation layer for protecting components disposed below the first passivation layer 114. The first passivation layer 114 may be configured as a single layer or multilayer made of silicon oxide (SiOx) or silicon nitride (SiNx). However, the present disclosure is not limited thereto.

The first planarization layer 115 is disposed on the first passivation layer 114. The first planarization layer 115 may planarize an upper portion of the substrate 110 on which the driving transistor DT and the storage capacitor Cst are disposed. The first planarization layer 115 may be configured as a single layer or multilayer and made of a photoresist or an acrylic-based organic material, for example. However, the present disclosure is not limited thereto.

The second passivation layer 116 is disposed on the first planarization layer 115. The second passivation layer 116 may be an insulation layer for protecting components disposed below the second passivation layer 116. The second passivation layer 116 may be configured as a single layer or multilayer made of silicon oxide (SiOx) or silicon nitride (SiNx). However, the present disclosure is not limited thereto.

The connection electrode 150 and the plurality of assembling electrodes 160 are disposed on the second passivation layer 116.

The connection electrode 150 is an electrode that electrically connects the driving transistor DT and a second connection electrode CE2. The connection electrode 150 may be electrically connected to the source electrode SE or the third capacitor electrode SC3 through contact holes formed in the second passivation layer 116, the first planarization layer 115, and the first passivation layer 114.

The connection electrode 150 may have a multilayer structure including a first connection layer 150a and a second connection layer 150b. The first connection layer 150a is disposed on the second passivation layer 116, and the second connection layer 150b is disposed to cover the first connection layer 150a. The second connection layer 150b may be disposed to surround both a top surface and a side surface of the first connection layer 150a.

The second connection layer 150b may be made of a material more resistant to corrosion than a material of the first connection layer 150a. Therefore, it is possible to minimize or at least reduce a short-circuit defect caused by migration between lines adjacent to the first connection layer 150a during the process of manufacturing the display device 1000. For example, the first connection layer 150a may be made of an electrically conductive material such as copper (Cu) and chromium (Cr). The second connection layer 150b may be made of molybdenum (Mo) and molybdenum titanium (MoTi). However, the present disclosure is not limited thereto.

The plurality of assembling electrodes 160 is disposed on the second passivation layer 116.

The assembling electrodes 160 include the first assembling electrode 162 and the second assembling electrode 163.

The plurality of first assembling electrodes 162 and the plurality of second assembling electrodes 163 may extend in the column direction in the plurality of subpixels SP and disposed to be spaced apart from one another at predetermined intervals.

The first assembling electrode 162 and the second assembling electrode 163 may be disposed to overlap the light-emitting element ED1. First, the first assembling electrode 162 may be disposed in an area corresponding to one side of the light-emitting element ED1. Among the assembling electrodes 160, the first assembling electrode 162 may be disposed in an area, which overlaps the low-potential power line, and electrically connected to the low-potential power line. The low-potential power line is a line for transmitting a low-potential power voltage to the light-emitting element ED1. The low-potential power line may extend in the column direction in each of the plurality of subpixels SP. For example, the low-potential power line may be disposed in each of the plurality of subpixels SP.

The second assembling electrode 163 may be spaced apart from the first assembling electrode 162 and disposed in an area corresponding to the other side of the light-emitting element ED1.

The plurality of assembling electrodes 160 each includes conductive layers 162a and 163a disposed on the second passivation layer 116, and clad layers 162b and 163b disposed on the conductive layers 162a and 163a and configured to cover all top and side surfaces of the conductive layers 162a and 163a.

The first assembling electrode 162 includes a first conductive layer 162a and a first clad layer 162b, and the second assembling electrode 163 includes a second conductive layer 163a and a second clad layer 163b.

The first conductive layer 162a and the second conductive layer 163a may not overlap the light-emitting element ED1. That is, an end of the first conductive layer 162a and an end of the second conductive layer 163a may be disposed outward of the light-emitting element ED1.

The first clad layer 162b of the first assembling electrode 162 may be disposed to cover the top and side surfaces of the first conductive layer 162a. In addition, the second clad layer 163b of the second assembling electrode 163 may be disposed to cover top and side surfaces of the second conductive layer 163a. In this case, the first clad layer 162b and the second clad layer 163b may extend from the end of the first conductive layer 162a and the end of the second conductive layer 163a toward a central portion of the light-emitting element ED1 and overlap the light-emitting element ED1.

The first conductive layer 162a and the second conductive layer 163a may be formed by the same process and made of the same material as the first connection layer 150a of the connection electrode 150. For example, the first conductive layer 162a and the second conductive layer 163a may be made of an electrically conductive material such as copper (Cu) and chromium (Cr). Further, the first clad layer 162b and the second clad layer 163b may be formed by the same process and made of the same material as the second connection layer 150b of the connection electrode 150. For example, the first clad layer 162b and the second clad layer 163b may each be made of a material more resistant to corrosion than materials of the first conductive layer 162a and the second conductive layer 163a. For example, the first clad layer 162b and the second clad layer 163b may each be made of molybdenum (Mo), molybdenum titanium (MoTi), and the like. However, the present disclosure is not limited thereto.

The third passivation layer 117 is disposed on the connection electrode 150 and the assembling electrode 160. The third passivation layer 117 may be an insulation layer for protecting components disposed below the third passivation layer 117. The third passivation layer 117 may be configured as a single layer or multilayer made of silicon oxide (SiOx) or silicon nitride (SiNx). However, the present disclosure is not limited thereto.

A partial area of the third passivation layer 117 may be opened in an area adjacent to the plurality of light-emitting elements ED1. For example, an area of the third passivation layer 117 adjacent to one side surface of two opposite surfaces of each of the plurality of light-emitting elements ED1, may be opened. For example, the third passivation layer 117 may expose a part of a top surface of the first assembling electrode 162 in the area adjacent to one side surface of each of the plurality of light-emitting elements ED1.

A bonding layer AD is disposed on the third passivation layer 117. The bonding layer AD may be disposed to overlap the light-emitting element ED1 and also overlap a part of the assembling electrode 160. The bonding layer AD may be an organic film that temporarily fixes the light-emitting element ED1 during the process of self-assembling the light-emitting element ED1. When the organic film is formed to cover the light-emitting element ED1 during the process of manufacturing the display device 1000, a space between the light-emitting element ED1, the third passivation layer 117, and the assembling electrode 160 is filled with a part of the organic film, such that the organic film may temporarily fix the light-emitting element ED1 onto the third passivation layer 117 and the assembling electrode 160. Thereafter, even though the organic film is removed, a part of the organic film, which permeates into a lower portion of the light-emitting element ED1, may remain without being removed, thereby defining the bonding layer. The bonding layer AD may be made of a photoresist or an organic material, for example, an acrylic-based organic material. However, the present disclosure is not limited thereto.

Meanwhile, with reference to FIG. 6, the concave-convex structure P is disposed on the bonding layer AD. The concave-convex structure P may be disposed in a shape corresponding to the concave pattern CP of the light-emitting element ED1 and disposed in the concave pattern CP.

The concave-convex structure P is disposed between the first assembling electrode 162 and the second assembling electrode 163. The concave-convex structure P may be disposed to overlap a portion of the first assembling electrode 162 and a portion of the second assembling electrode 163 or disposed so as not to overlap the first assembling electrode 162 and the second assembling electrode 163.

One or more light-emitting elements ED1 are disposed on the bonding layer AD and the concave-convex structure P in one subpixel SP. The light-emitting element ED1 is an element that emits light by receiving an electric current. The light-emitting elements ED1 may include the light-emitting elements ED1 configured to emit red light, green light, blue light, and the like. The light-emitting elements ED1 may implement light with various colors including white by using a combination of red light, green light, blue light, and the like. In addition, light beams with various colors may be implemented by using the light-emitting element ED1, which emits light with a particular color, and a photoconversion member that converts the light from the light-emitting element ED1 into light with a color different from the particular color.

With reference to FIG. 6, the light-emitting element ED1 includes the first semiconductor layer 121, the light-emitting layer 122, the second semiconductor layer 123, the first electrode 124, the second electrode 125, the encapsulation layer 126, the auxiliary electrode 127, and the concave pattern CP. With reference to FIG. 6, the concave pattern CP is disposed in a shape corresponding to the concave-convex structure P and disposed to surround the side and top surfaces of the concave-convex structure P.

Hereinafter, the description is made on the assumption that the plurality of light-emitting elements ED1 has the vertical structure. However, the types of the plurality of light-emitting elements ED1 are not limited thereto. In addition, in FIG. 6, the plurality of light-emitting elements ED1 is described as adopting the red light-emitting element 120 of the light-emitting element ED1 described with reference to FIGS. 1 and 2A. However, the present disclosure is not limited thereto. Both the green light-emitting element 130 and the blue light-emitting element 140, which have been described with reference to FIGS. 2B and 2C, may be applied. Because the plurality of light-emitting elements ED1 has been described in detail with reference to FIGS. 1 to 2C, a repeated description will be omitted.

The second planarization layer 118 is disposed on the third passivation layer 117. The second planarization layer 118 may be configured as a single layer or multilayer and made of a photoresist or an acrylic-based organic material, for example. However, the present disclosure is not limited thereto.

In addition, the second planarization layer 118 may be disposed to surround a part of the side surface portion of each of the plurality of light-emitting elements ED1. For example, the second planarization layer 118 may be disposed to surround a lower side surface of the first semiconductor layer 121 extending from the bottom surface of the first semiconductor layer 121 of each of the plurality of light-emitting elements ED1 on the third passivation layer 117 and the assembling electrode 160. In this case, a top surface of the second planarization layer 118 may be disposed below a top surface of the first electrode 124 of each of the plurality of light-emitting elements ED1. However, the present disclosure is not limited thereto.

A first connection electrode CE1 is disposed on the second planarization layer 118. The first connection electrode CE1 may be disposed on the side surface of the light-emitting element ED1 and electrically connect the light-emitting element ED1 and the assembling electrode 160. The first connection electrode CE1 may be disposed in an area, which overlaps the first assembling electrode 162, and surround at least a part of the first semiconductor layer 121 and at least a part of the first electrode 124 of the light-emitting element ED1. Meanwhile, the first connection electrode CE1 may extend to an upper portion of the first electrode 124 of the light-emitting element ED1 and being in contact with a part of the auxiliary electrode 127. However, the present disclosure is not limited thereto.

In this case, the first connection electrode CE1 may be electrically connected to the first assembling electrode 162 exposed by the third passivation layer 117, in an area in which the third passivation layer 117 is opened. In addition, the first connection electrode CE1 may be disposed on the first electrode 124 of the light-emitting element ED1 and extend to an upper side of the second planarization layer 118.

Meanwhile, the first electrode 124 of the light-emitting element ED1 may be electrically connected to the first assembling electrode 162 without being connected to the second assembling electrode 163, such that the first electrode 124 of the light-emitting element ED1 may be in a state of being insulated directly from the second assembling electrode 163. However, the present disclosure is not limited thereto. For example, FIG. 6 illustrates that the first connection electrode CE1 is not disposed on the other side surface of the light-emitting element ED1. However, the present disclosure is not limited thereto. The first connection electrode CE1 may be disposed to surround the side surface of the light-emitting element ED1. Therefore, the first connection electrode CE1 may be electrically connected to both the first assembling electrode 162 and the second assembling electrode 163. However, the present disclosure is not limited thereto.

The third planarization layer 119 is disposed on the light-emitting element ED1 and the first connection electrode CE1. The third planarization layer 119 may planarize the upper portion of the substrate 110 on which the light-emitting element ED1 is disposed. The third planarization layer 119, together with the bonding layer AD, may fix the light-emitting element ED1 onto the substrate 110.

Therefore, the third planarization layer 119 may be disposed on one side surface of the light-emitting element ED1 and adjoin the first connection electrode CE1, and the third planarization layer 119 may be disposed on the other side surface of the light-emitting element ED1 and adjoin the side surface of the light-emitting element.

Meanwhile, the drawings illustrate that the third planarization layer 119 is a single layer. However, the present disclosure is not limited thereto. The third planarization layer 119 may be configured as a single layer or multilayer and made of a photoresist or an acrylic-based organic material, for example. However, the present disclosure is not limited thereto.

The second connection electrode CE2 is disposed on the third planarization layer 119.

The second connection electrode CE2 is an electrode that electrically connects the plurality of light-emitting elements ED1 and the connection electrode 150. With reference to FIG. 6, the second connection electrode CE2 may be electrically connected to the connection electrode 150 and the driving transistor DT through a contact hole formed in the second planarization layer 118.

The second connection electrode CE2 may be made of an electrically conductive material, e.g., a transparent conductive material such as indium tin oxide (ITO) or indium zinc oxide (IZO). However, the present disclosure is not limited thereto.

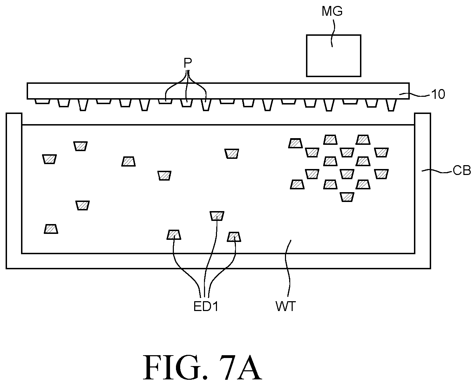

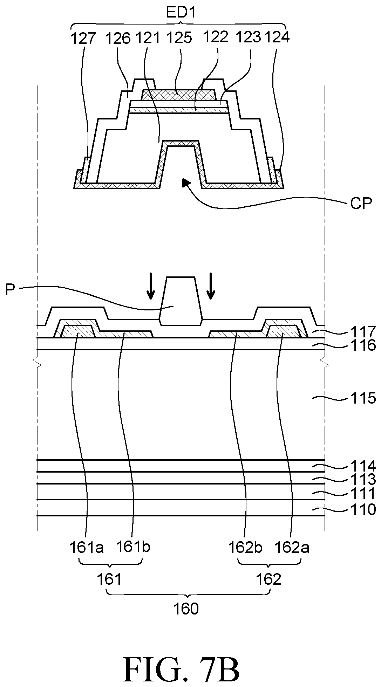

Hereinafter, a method of manufacturing the display device 1000 according to the embodiment of the present specification will be described with reference to FIGS. 7A and 7B.

FIGS. 7A and 7B are cross-sectional views for explaining a method of manufacturing the display device according to the embodiment of the present disclosure. With reference to FIG. 7A, the plurality of light-emitting elements ED1 is loaded into a chamber CB filled with a fluid WT. The fluid WT may include water or the like, and the chamber CB filled with the fluid WT may have a shape opened at an upper side thereof.

Next, a mother substrate 10 may be positioned on the chamber CB filled with the light-emitting elements ED1. The mother substrate 10 is a substrate including a plurality of substrates 110 constituting the display device 1000, and the mother substrate 10 may be cut and divided into the plurality of substrates 110 later. In order to self-assemble the plurality of light-emitting elements ED1, the mother substrate 10 having the plurality of low-potential power lines and the third passivation layer 117 may be used.

Specifically, with reference to FIG. 7B, the buffer layer 111, the gate insulation layer 112, the first interlayer insulation layer 113, the first passivation layer 114, the first planarization layer 115, and the second passivation layer 116 are sequentially formed on the substrate 110 together with the plurality of lines and the pixel circuit, and the assembling electrode 160 on the second passivation layer 116.

After the display device 1000 is completely manufactured, the assembling electrodes 160 may serve as a pair of low-potential power lines. During the process of manufacturing the display device 1000, different voltages may be applied to the two adjacent assembling electrodes 160. After the process of manufacturing the display device 1000 is completed, the same low-potential power voltage may be applied to the two adjacent assembling electrodes 160.

The assembling electrodes 160 include the first assembling electrode 162 and the second assembling electrode 163.

The first assembling electrode 162 is disposed on the second passivation layer 116. The first assembling electrode 162 includes the first clad layer 162b configured to cover the first conductive layer 162a and the first conductive layer 162a.

The second assembling electrode 163 is disposed on the second passivation layer 116. The second assembling electrode 163 includes the second clad layer 163b configured to cover the second conductive layer 163a and the second conductive layer 163a.

Next, the third passivation layer 117 is formed on the assembling electrode 160.

Therefore, the substrate 110 and the plurality of light-emitting elements ED1, which are illustrated in FIG. 7B, may be loaded into the chamber CB filled with the fluid WT, and an electric field may be formed by applying an alternating current voltage to the assembling electrode 160. Therefore, an electric field may be formed between the first assembling electrode 162 and the second assembling electrode 163.

The light-emitting element ED1 may have a polarity by being dielectrically polarized by the electric field. Further, the dielectrically polarized light-emitting element ED1 may be fixed or moved in a particular direction by dielectrophoresis (DEP), i.e., the electric field. Therefore, the dielectrophoresis may be used to self-assemble the plurality of light-emitting elements ED1 onto the assembling electrode 160.

With reference to FIG. 7B, the plurality of concave-convex structures P is disposed on the third passivation layer 117. The plurality of concave-convex structures P is disposed to correspond to the concave patterns CP of the light-emitting elements ED1. Therefore, the light-emitting element ED1 may be seated on the concave-convex structure P and self-assembled.

The plurality of concave-convex structures P include a plurality of first concave-convex structures disposed in a plurality of first subpixels, a plurality of second concave-convex structures disposed in a plurality of second subpixels, and a plurality of third concave-convex structures disposed in a plurality of third subpixels. The plurality of first concave-convex structures, the plurality of second concave-convex structures, and the plurality of third concave-convex structures may be formed to correspond to the first concave patterns CP1 of the plurality of red light-emitting elements 120, the second concave patterns CP2 of the plurality of green light-emitting elements 130, and the third concave patterns CP3 of the plurality of blue light-emitting elements 140, which are illustrated in FIGS. 2A to 2C, and have sizes corresponding to the first concave pattern CP1, the second concave pattern CP2, and the third concave pattern CP3. For example, the plurality of first concave-convex structures, the plurality of second concave-convex structures, and the plurality of third concave-convex structures may have planar shapes that are circular shapes. The widths may increase in the order of the plurality of first concave-convex structures, the plurality of second concave-convex structures, and the plurality of third concave-convex structures, and the heights may decrease in the order of the plurality of first concave-convex structures, the plurality of second concave-convex structures, and the plurality of third concave-convex structures. Therefore, only the red light-emitting element 120 may be self-assembled to the first concave pattern CP1, only the green light-emitting element 130 may be self-assembled to the second concave pattern CP2, and only the blue light-emitting element 140 may be self-assembled to the third concave pattern CP3.

Meanwhile, although not illustrated in FIG. 7B, an organic layer and an opening portion may be additionally disposed on the third passivation layer 117. The organic layer may be disposed to surround the plurality of concave-convex structures P and include a plurality of layers to easily adjust the height.

A plurality of opening portions may be disposed to overlap the plurality of concave-convex structures P. The plurality of opening portions may be formed to correspond to the plurality of first subpixels, the plurality of second subpixels, and the plurality of third subpixels. For example, a plurality of first opening portions may have shapes corresponding to the planar shape of the red light-emitting element 120, a plurality of second opening portions may have shapes corresponding to the planar shape of the green light-emitting element 130, and a plurality of third opening portion may have shapes corresponding to the planar shape of the blue light-emitting element 140. Therefore, the plurality of opening portions may facilitate the self-assembling of the plurality of light-emitting elements ED1. However, the present disclosure is not limited thereto.

Lastly, when the plurality of light-emitting elements ED 1 is completely self-assembled, the other components, such as the bonding layer AD, the first connection electrode CE1, the second connection electrode CE2, the second planarization layer 118, and the third planarization layer 119, are formed, such that the process of manufacturing the display device 1000 may be completed.

Therefore, in the display device 1000 according to the embodiment of the present disclosure, the plurality of concave-convex structures P, which corresponds to the concave patterns CP of the plurality of light-emitting elements ED1, is disposed on the mother substrate 10. For example, among the plurality of concave patterns CP, the widths increase in the order of the first concave pattern CP1, the second concave pattern CP2, and the third concave pattern CP3, and the heights decrease in the order of the first concave pattern CP1, the second concave pattern CP2, and the third concave pattern CP3. In this case, the concave-convex structures P are also disposed such that widths increase in the order of the first concave-convex structure, the second concave-convex structure, and the third concave-convex structure, whereas heights decrease in the order of the first concave-convex structure, the second concave-convex structure, and the third concave-convex structure. Therefore, the red light-emitting element 120, the green light-emitting element 130, and the blue light-emitting element 140 may be respectively self-assembled to the first concave-convex structure, the second concave-convex structure, and the third concave-convex structure. Therefore, it is possible to suppress a color mixture defect in which the light-emitting elements ED1, which emit light beams with different colors, are disposed in one subpixel SP. Therefore, in the display device 1000 according to the embodiment of the present disclosure, the assembling rate of the light-emitting element ED1 may be improved.

In addition, in the display device 1000 according to the embodiment of the present disclosure, the opening portion for assembling the light-emitting element ED1 may not be separately formed in the mother substrate 10. In the related art, the self-assembling is performed in a state in which the plurality of opening portions is formed to have different outer diameters. For example, a first opening portion is formed in a circular shape while corresponding to an outer diameter of a red light-emitting element, a second opening portion is formed in an elliptical shape while corresponding to an outer diameter of a green light-emitting element, and a third opening portion is formed in an elliptical shape different from the shape of the second opening portion, while corresponding to an outer diameter of a blue light-emitting element. In contrast, in the display device 1000 according to the embodiment of the present disclosure, only the light-emitting elements ED1 having particular shapes may be self-assembled to the plurality of concave-convex structures P by disposing only the plurality of concave-convex structures P having different shapes even though the opening portion is not formed. Therefore, in the display device 1000 according to the embodiment of the present disclosure, the process of forming the plurality of opening portions and the organic layer and the process of removing the organic layer after the self-assembling are not performed, which may reduce the process costs and the number of processes.

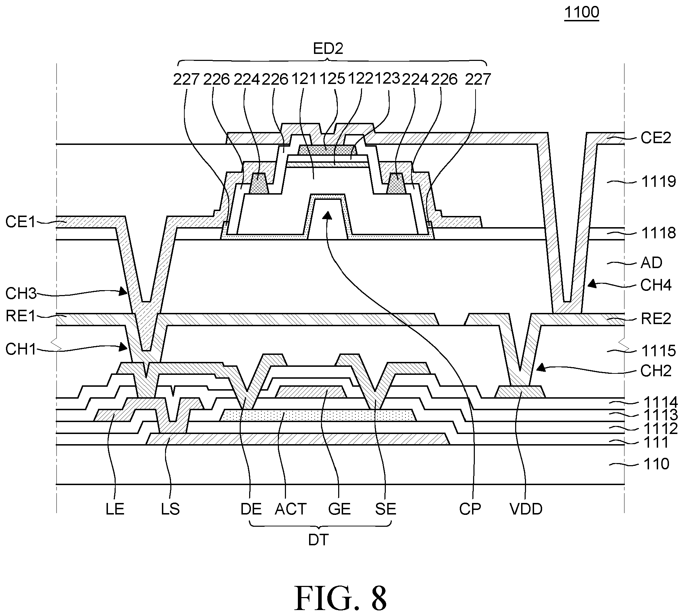

FIG. 8 is a cross-sectional view of a pixel area of a display device according to another embodiment of the present disclosure.

With reference to FIG. 8, the substrate 110, the buffer layer 111, a gate insulation layer 1112, a first interlayer insulation layer 1113, a second interlayer insulation layer 1114, a first planarization layer 1115, the bonding layer AD, a second planarization layer 1118, a third planarization layer 1119, the driving transistor DT, the light-emitting element ED2, a plurality of reflective electrodes RE, a plurality of connection electrodes CE, the light-blocking layer LS, and an auxiliary line LE are disposed in each of the plurality of subpixels SP of a display device 1100 according to another embodiment of the present disclosure.

The light-blocking layer LS and the buffer layer 111 are disposed in each of the plurality of subpixels SP on the substrate 110.

The driving transistor DT is disposed on the buffer layer 111. The driving transistor DT includes the active layer ACT, the gate electrode GE, the source electrode SE, and the drain electrode DE.

The active layer ACT is disposed on the buffer layer 111. The active layer ACT may be made of a semiconductor material such as an oxide semiconductor, amorphous silicon, or polysilicon. However, the present disclosure is not limited thereto.

The gate insulation layer 1112 is disposed on the active layer ACT. FIG. 8 illustrates that the gate insulation layer 1112 is disposed on the front surface of the substrate 110. However, the present disclosure is not limited thereto. The gate insulation layer 1112 may be disposed to overlap only the gate electrode GE.

The gate electrode GE is disposed on the gate insulation layer 1112.

The first interlayer insulation layer 1113 and the second interlayer insulation layer 1114 are disposed on the gate electrode GE. Contact holes, through which the source electrode SE and the drain electrode DE are connected to the active layer ACT, are formed in the first interlayer insulation layer 1113 and the second interlayer insulation layer 1114.

The source electrode SE and the drain electrode DE are disposed on the second interlayer insulation layer 1114 and electrically connected to the active layer ACT.

Meanwhile, in the present disclosure, the configuration has been described in which the first interlayer insulation layer 1113 and the second interlayer insulation layer 1114, i.e., the plurality of insulation layers is disposed between the gate electrode GE, the source electrode SE, and the drain electrode DE. However, only a single insulation layer may be disposed between the gate electrode GE, the source electrode SE, and the drain electrode DE. However, the present disclosure is not limited thereto.

Further, as illustrated in FIG. 8, in case that the plurality of insulation layers, such as the first interlayer insulation layer 1113 and the second interlayer insulation layer 1114, is disposed between the gate electrode GE, the source electrode SE, and the drain electrode DE, an electrode may be additionally formed between the first interlayer insulation layer 1113 and the second interlayer insulation layer 1114. The additionally formed electrode may define a capacitor together with other components disposed on the lower portion of the first interlayer insulation layer 1113 or the upper portion of the second interlayer insulation layer 1114.

The auxiliary line LE is disposed on the gate insulation layer 1112. The auxiliary line LE is an electrode that electrically connects the light-blocking layer LS disposed below the buffer layer 111, to any one of the source electrode SE and the drain electrode DE on the second interlayer insulation layer 1114. For example, the light-blocking layer LS may be electrically connected to any one of the source electrode SE or the drain electrode DE through the auxiliary line LE so as not to be operated as a floating gate, thereby minimizing a change in threshold voltage of the driving transistor DT caused by the floating light-blocking layer LS. FIG. 8 illustrates that the light-blocking layer LS is connected to the drain electrode DE. However, the light-blocking layer LS may be connected to the source electrode SE. However, the present disclosure is not limited thereto.

The power line VDD is disposed on the second interlayer insulation layer 1114. The power line VDD may be electrically connected to the light-emitting element ED2 together with the driving transistor DT and allow the light-emitting element ED2 to emit light. The power line VDD may be made of an electrically conductive material, for example, copper (Cu), aluminum (Al), molybdenum (Mo), nickel (Ni), titanium (Ti), chromium (Cr), or an alloy thereof. However, the present disclosure is not limited thereto.

The first planarization layer 1115 is disposed on the driving transistor DT and the power line VDD. The first planarization layer 1115 may planarize the upper portion of the substrate 110 on which the driving transistor DT is disposed.

The plurality of reflective electrodes RE spaced apart from one another, is disposed on the first planarization layer 1115. The plurality of reflective electrodes RE may serve to electrically connect the light-emitting element ED2 to the power line VDD and the driving transistor DT and serve as a reflective plate that reflects light emitted from the light-emitting element ED2 to an upper portion of the light-emitting element ED2. The plurality of reflective electrodes RE may each be made of an electrically conductive material having excellent reflection performance and reflect the light emitted from the light-emitting element ED2, toward the upper portion of the light-emitting element ED2.

The plurality of reflective electrodes RE include a first reflective electrode RE1 and a second reflective electrode RE2. The first reflective electrode RE1 may electrically connect the driving transistor DT and the light-emitting element ED2. The first reflective electrode RE1 may be connected to the source electrode SE or the drain electrode DE of the driving transistor DT through a contact hole CH1 formed in the first planarization layer 1115. Further, the first reflective electrode RE1 may be electrically connected to the first electrode 224 and the first semiconductor layer 121 of the light-emitting element ED2 through the first connection electrode CE1 to be described below.

The second reflective electrode RE2 may electrically connect the power line VDD and the light-emitting element ED2. The second reflective electrode RE2 may be connected to the power line VDD through a contact hole CH2 formed in the first planarization layer 1115, and electrically connected to the second electrode 125 and the second semiconductor layer 123 of the light-emitting element ED2 through the second connection electrode CE2 to be described below.

The bonding layer AD is disposed on the plurality of reflective electrodes RE. A third contact hole CH3, through which the first connection electrode CE1 is connected to the first reflective electrode RE1, is disposed in the bonding layer AD, and a fourth contact hole CH4, through which the second connection electrode CE2 is connected to the second reflective electrode RE2, is disposed in the bonding layer AD. The front surface of the substrate 110 may be coated with the bonding layer AD, and the bonding layer AD may fix the light-emitting element ED2 disposed on the bonding layer AD.

The plurality of light-emitting elements ED2 is disposed on the bonding layer AD in each of the plurality of subpixels SP.

With reference to FIG. 8, the light-emitting element ED2 includes the first semiconductor layer 121, the light-emitting layer 122, the second semiconductor layer 123, the first electrode 224, the second electrode 125, the encapsulation layer 226, and the protective layer 227. Hereinafter, the description is made on the assumption that the plurality of light-emitting elements ED2 has the lateral structure. However, the types of the plurality of light-emitting elements ED2 are not limited thereto. In addition, FIG. 8 illustrates that the light-emitting element ED2 described with reference to FIG. 4 is applied to the plurality of light-emitting elements ED2. Because the light-emitting element ED2 has been described in detail with reference to FIG. 4, a repeated description will be omitted.

The bonding layer AD may be disposed outside the concave pattern CP and bonded to the bottom surface of the light-emitting element ED2, and the inside of the concave pattern CP may be filled with the bonding layer AD. Meanwhile, an airgap (air) may be disposed in the concave pattern CP. For example, an airgap (air) may be disposed in an upper area of the concave pattern CP. However, the present disclosure is not limited thereto. The entire concave pattern CP may be filled with the bonding layer AD.

The second planarization layer 1118 and the third planarization layer 1119 are disposed on the bonding layer AD. The second planarization layer 1118 may partially overlap the side surfaces of the plurality of light-emitting elements ED2 and fix and protect the plurality of light-emitting elements ED2.

Further, the first connection electrode CE1 is disposed on the second planarization layer 1118. The first connection electrode CE1 may be connected to the first reflective electrode RE1 through the third contact hole CH3 formed in the second planarization layer 118 and the bonding layer AD. Therefore, the first connection electrode CE1 may be electrically connected to any one of the source electrode SE and the drain electrode DE of the driving transistor DT through the first reflective electrode RE1. Further, the first connection electrode CE1 may be connected to the first electrode 224 of each of the plurality of light-emitting elements ED2.

The first connection electrode CE1 may be disposed to surround the side surface of each of the plurality of light-emitting elements ED2.

The third planarization layer 1119 is disposed on the first connection electrode CE1 and the plurality of light-emitting elements ED2.

The second connection electrode CE2 is disposed on the third planarization layer 1119. The second connection electrode CE2 is an electrode that electrically connects the light-emitting element ED2 and the power line VDD. The second connection electrode CE2 may be connected to the second reflective electrode RE2 through the fourth contact hole CH4 formed in the third planarization layer 1119, the second planarization layer 1118, and the bonding layer AD. Therefore, the second connection electrode CE2 may be electrically connected to the power line VDD through the second reflective electrode RE2. Further, the second connection electrode CE2 may be connected to the second electrode 125 of each of the plurality of light-emitting elements ED2 through the contact hole formed in the third planarization layer 1119. Therefore, the second connection electrode CE2 may electrically connect the power line VDD and the second electrode 125 and the second semiconductor layer 123 of each of the plurality of light-emitting elements ED2.

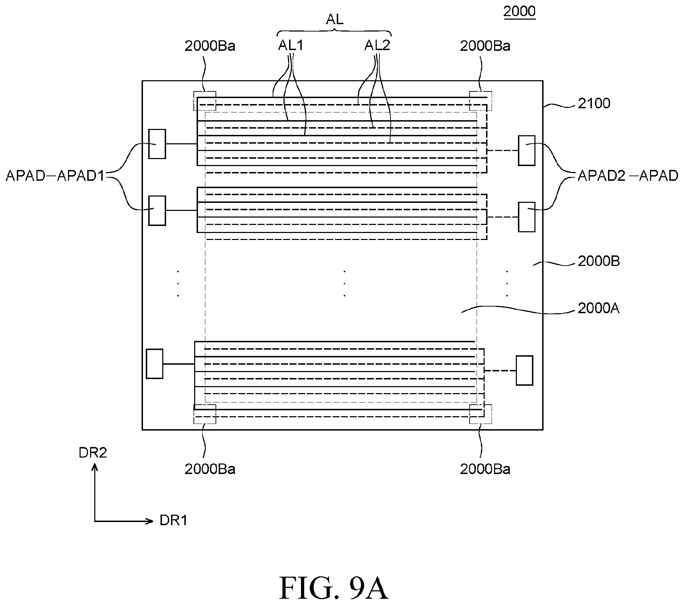

Hereinafter, a method of manufacturing the display device 1100 according to another embodiment of the present disclosure will be described with reference to FIGS. 9A to 9H.

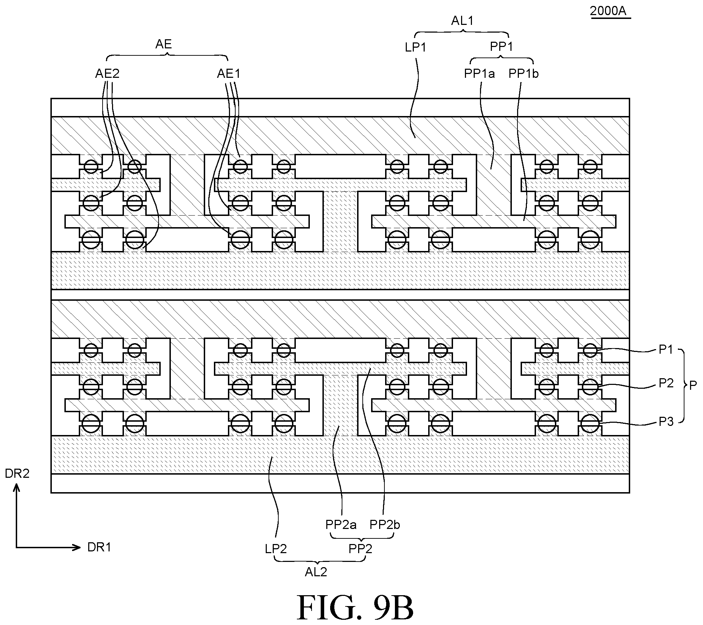

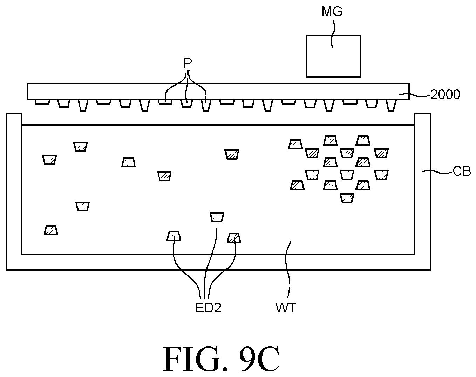

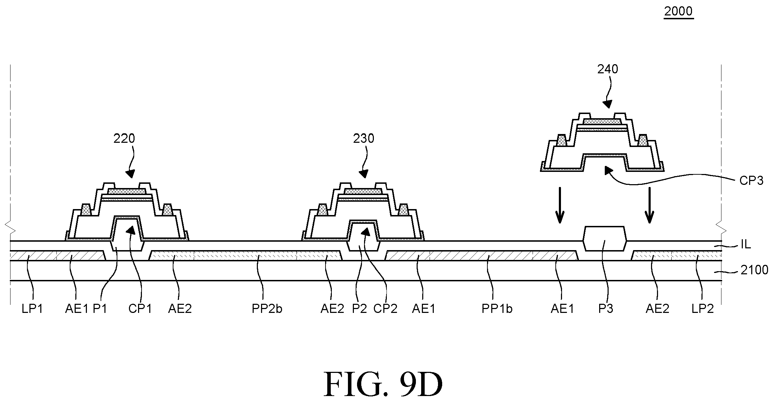

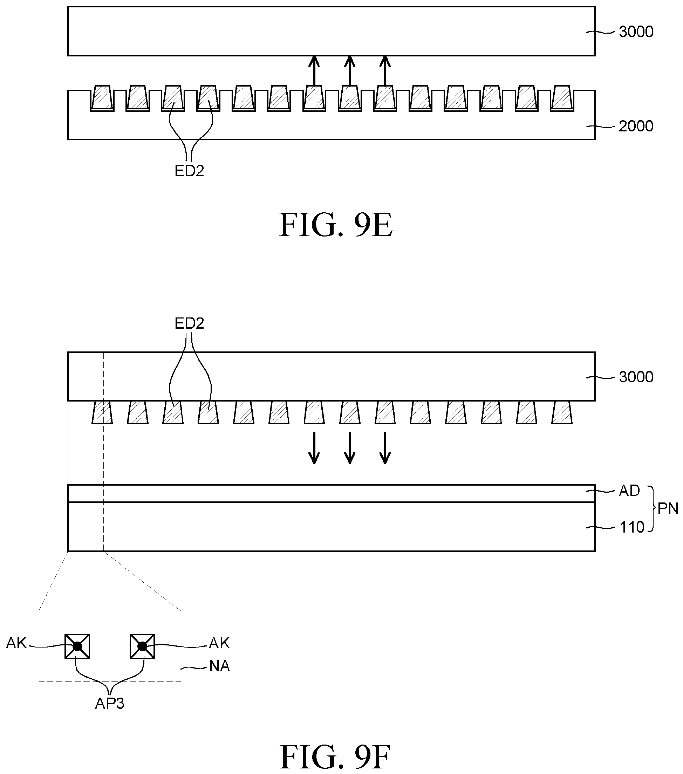

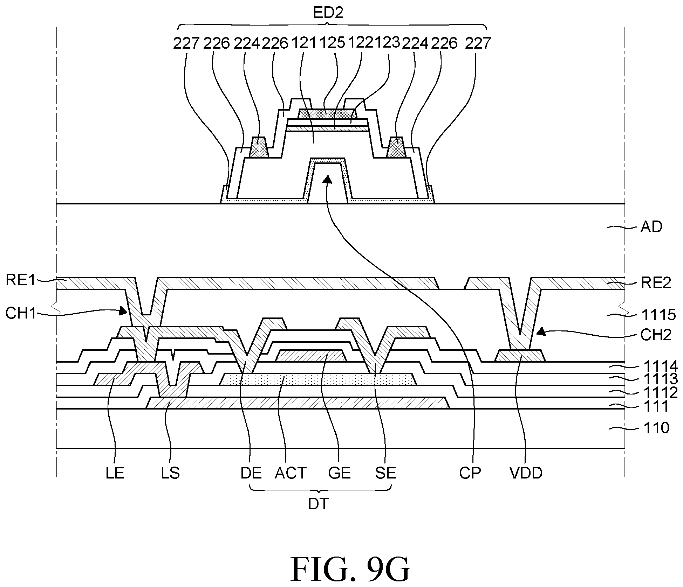

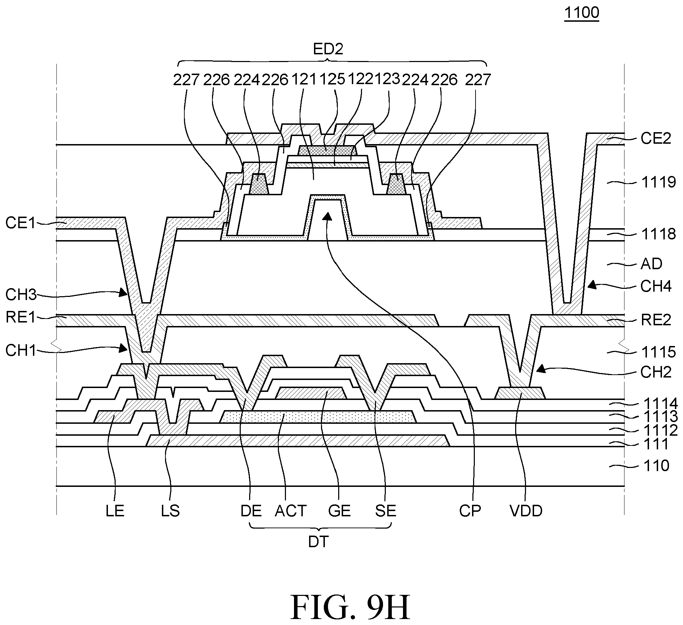

FIGS. 9A to 9H are process diagrams for explaining a method of manufacturing the display device according to another embodiment of the present disclosure. FIG. 9A is a top plan view of an assembling substrate 2000 according to an embodiment of the present disclosure. FIG. 9B is an enlarged top plan view of an assembling area 2000A of the assembling substrate 2000 of the display device according to the embodiment of the present disclosure. FIGS. 9C and 9D are views for explaining a process of self-assembling the plurality of light-emitting elements ED2 onto the assembling substrate 2000 according to the embodiment of the present disclosure. FIG. 9E is a view for explaining a process of transferring the plurality of light-emitting elements ED2 on the assembling substrate 2000 to a donor 3000 according to the embodiment of the present disclosure. FIGS. 9F and 9G are views for explaining a process of transferring the plurality of light-emitting elements ED2 on the donor 3000 to the display panel PN according to the embodiment of the present disclosure. FIG. 9H is a cross-sectional view of the display device 1100 for explaining a process of forming the first connection electrode CE1 and the second connection electrode CE2 according to the embodiment of the present disclosure.

With reference to FIG. 9A, the assembling substrate 2000 includes the assembling area 2000A and an outer peripheral area 2000B. The assembling area 2000A is an area in which the plurality of light-emitting elements ED2 are self-assembled. A plurality of assembling lines AL and a plurality of assembling electrodes AE are disposed in the assembling area 2000A to self-assemble the light-emitting element ED2. The outer peripheral area 2000B is the remaining area excluding the assembling area 2000A. A plurality of assembling pads, a plurality of alignment keys, and the like may be disposed in the outer peripheral area 2000B.

With reference to FIGS. 9B to 9D together, the assembling substrate 2000 includes an assembly substrate 2100, the plurality of assembling lines AL, the plurality of assembling electrodes AE, the plurality of assembling pads, the plurality of concave-convex structures P, and an assembling insulation layer IL.

First, with reference to FIGS. 9B to 9C, the plurality of assembling lines AL and the plurality of assembling electrodes AE are disposed on the assembly substrate 2100 in the assembling area 2000A.

The plurality of assembling lines AL include a plurality of first assembling lines AL1 and a plurality of second assembling lines AL2. The plurality of first assembling lines AL1 and the plurality of second assembling lines AL2 may be disposed to be spaced apart from one another at predetermined intervals. The plurality of first assembling lines AL1 and the plurality of second assembling lines AL2 may be alternately disposed. Different voltages may be applied to the plurality of first assembling lines AL1 and the plurality of second assembling lines AL2, such that an electric field may be formed between the plurality of first assembling lines AL1 and the plurality of second assembling lines AL2. Further, the plurality of light-emitting elements ED2 may be self-assembled between the plurality of first assembling lines AL1 and the plurality of second assembling lines AL2 by using the electric field formed between the plurality of first assembling lines AL1 and the plurality of second assembling lines AL2.

The plurality of first assembling lines AL1 each includes a first line portion LP1 and a plurality of first protruding portions PP1. The first line portion LP1 is a portion extending straight in a first direction DR1 in the assembling area 2000A. The first line portion LP1 may extend from the assembling area 2000A to the outer peripheral area 2000B and be electrically connected to the plurality of assembling pads in the outer peripheral area 2000B.

The plurality of second assembling lines AL2 each includes a second line portion LP2 and a plurality of second protruding portions PP2. The second line portion LP2 is a portion extending straight in a second direction DR2 in the assembling area 2000A. The second line portion LP2 may extend from the assembling area 2000A to the outer peripheral area 2000B and be electrically connected to the plurality of assembling pads in the outer peripheral area 2000B.

The plurality of assembling electrodes AE include a plurality of first assembling electrodes AE1 and a plurality of second assembling electrodes AE2. The plurality of first assembling electrodes AE1 may be connected to the plurality of first assembling lines AL1, and the plurality of second assembling electrodes AE2 may be connected to the plurality of second assembling lines AL2. The pair of first and second assembling electrodes AE1 and AE2 may be disposed adjacent to each other and form an electric field for self-assembling the light-emitting element ED2. In the plurality of subpixels SP, the pair of first and second assembling electrodes AE1 and AE2 may be disposed to correspond to the exact position to which the light-emitting element ED2 is transferred.

Further, any one of the red light-emitting element, the green light-emitting element, and the blue light-emitting element may be self-assembled with an interval and arrangement corresponding to each of the plurality of subpixels SP between the first assembling electrode AE1 and the second assembling electrode AE2 that face each other. For example, the red light-emitting element may be self-assembled between the first assembling electrode AE1 of the first line portion LP1 and the second assembling electrode AE2 of a fourth portion PP2b that face each other, the green light-emitting element may be self-assembled between the first assembling electrode AE1 of a second portion PP1b and the second assembling electrode AE2 of the fourth portion PP2b that face each other, and the blue light-emitting element may be self-assembled between the first assembling electrode AE1 of the second portion PP1b and the second assembling electrode AE2 of the second line portion LP2 that face each other.

Therefore, the plurality of first protruding portions PP1 and the plurality of second protruding portions PP2 are disposed in a staggered manner between one first assembling line AL1 and one second assembling line AL2 that are adjacent to each other, such that the red light-emitting element of the first subpixel, the green light-emitting element of the second subpixel, and the blue light-emitting element of the third subpixel may be self-assembled at once.

With reference to FIG. 9A together, the plurality of assembling pads is disposed on the assembling substrate 2000 in the outer peripheral area 2000B. The plurality of assembling pads include a plurality of first assembling pads APAD1 and a plurality of second assembling pads APAD2. The plurality of first assembling lines AL1 and the plurality of first assembling electrodes AE1 may be connected to the plurality of first assembling pads APAD1 and receive voltages, and the plurality of second assembling lines AL2 and the plurality of second assembling electrodes AE2 may be connected to the plurality of second assembling pads APAD2 and receive voltages. Some first assembling lines AL1, among the plurality of first assembling lines AL1, may be connected to one first assembling pad APAD1, and some second assembling lines AL2, among the plurality of second assembling lines AL2, may be connected to one second assembling pad APAD2.

Next, with reference to FIG. 9D together, the assembling insulation layer IL is disposed on the plurality of assembling lines AL and the plurality of assembling electrodes AE. The assembling insulation layer IL may protect the plurality of assembling lines AL and the plurality of assembling electrodes AE from the fluid WT, thereby suppressing a defect such as corrosion of the plurality of assembling lines AL.

With reference to FIGS. 9B and 9D, the plurality of concave-convex structures P is disposed on the plurality of assembling lines AL and the plurality of assembling electrodes AE.

The plurality of concave-convex structures P may be disposed to overlap an area between the first assembling electrode AE1 and the second assembling electrode AE2. The plurality of concave-convex structures P may not overlap the first assembling electrode AE1 and the second assembling electrode AE2 or be disposed to overlap the first assembling electrode AE1 and the second assembling electrode AE2.

Further, thereafter, the plurality of concave-convex structures P may be formed at positions respectively corresponding to the plurality of subpixels SP of the display device 1000. The plurality of concave-convex structures P may be disposed to respectively correspond to the plurality of subpixels SP in a one-to-one manner. The light-emitting elements ED2 self-assembled to the plurality of concave-convex structures P may be transferred to the plurality of subpixels SP in an intact manner. For example, the plurality of concave-convex structures P include a plurality of first concave-convex structures P1, a plurality of second concave-convex structures P2, and a plurality of third concave-convex structures P3 that are different in sizes. The plurality of first concave-convex structures P1, the plurality of second concave-convex structures P2, and the plurality of third concave-convex structures P3 may be arranged to respectively correspond to the first subpixel, the second subpixel, and the third subpixel.

The plurality of first concave-convex structures P1, the plurality of second concave-convex structures P2, and the plurality of third concave-convex structures P3 may be identical in planar shapes to one another. For example, all the plurality of first concave-convex structures P1, the plurality of second concave-convex structures P2, and the plurality of third concave-convex structures P3 may have circular planar shapes. However, the widths may increase in the order of the plurality of first concave-convex structures P1, the plurality of second concave-convex structures P2, and the plurality of third concave-convex structures P3, and the heights may decrease in the order of the plurality of first concave-convex structures P1, the plurality of second concave-convex structures P2, and the plurality of third concave-convex structures P3. Therefore, the plurality of first concave-convex structures P1, the plurality of second concave-convex structures P2, and the plurality of third concave-convex structures P3 are disposed to have different sizes, such that the light-emitting elements ED2 may be easily self-assembled.

Meanwhile, the plurality of first concave-convex structures P1, the plurality of second concave-convex structures P2, and the plurality of third concave-convex structures P3 may be different in planar shapes. For example, the plurality of first concave-convex structures P1 may each have a circular planar shape, the plurality of second concave-convex structures P2 may each have an elliptical or polygonal planar shape, and the plurality of third concave-convex structures P3 may each have an elliptical or polygonal planar shape different from the planar shape of the second concave-convex structure P2. However, the present disclosure is not limited thereto.

The plurality of concave-convex structures P is made of an insulating material. For example, the plurality of concave-convex structures P may be made of a photoresist or an organic material such as an acrylic-based material. However, the present disclosure is not limited thereto.

Meanwhile, although not illustrated in FIG. 9D, an organic layer including a plurality of opening portions may be disposed on the plurality of assembling lines AL and the plurality of assembling electrodes AE. The organic layer may include a plurality of layers to easily adjust the thickness. However, the present disclosure is not limited thereto.

The organic layer may include the plurality of opening portions. Thereafter, the plurality of opening portions may each be formed at positions respectively corresponding to the plurality of subpixels SP of the display device 1000. The plurality of opening portions may be disposed to correspond to the planar shapes of the light-emitting elements ED2, such that the light-emitting elements ED2 may be easily self-assembled.

With reference to FIG. 9C, the plurality of light-emitting elements ED2 are self-assembled onto the assembling substrate 2000.

First, the plurality of light-emitting elements ED2 grown on a wafer is loaded into the chamber CB filled with the fluid WT. The fluid WT may include water or the like, and the chamber CB filled with the fluid WT may have a shape opened at an upper side thereof.

Next, the assembling substrate 2000 may be positioned on the chamber CB filled with the light-emitting elements ED2. The assembling substrate 2000 may be disposed such that the plurality of concave-convex structures P of the assembling substrate 2000 faces the chamber CB.

Next, a magnet MG may be positioned on the assembling substrate 2000. The light-emitting elements ED2, which are submerged or suspended on a bottom of the chamber CB, may be moved toward the assembling substrate 2000 by a magnetic force of the magnet MG.

In this case, the light-emitting element ED2 may include a magnetic element so that the light-emitting element ED1 may be moved by a magnetic field. For example, any one of the first electrode 224 and the second electrode 125 of the light-emitting element ED2 may include ferromagnetic materials such as iron (Fe), cobalt (Co), or nickel (Ni), such that a direction of the light-emitting element ED2 directed toward the magnet MG may be aligned.

Next, with reference to FIG. 9D, the light-emitting element ED2, which has been moved toward the assembling substrate 2000 by the magnet MG, may be self-assembled to the assembling substrate 2000 by an electric field formed between the plurality of assembling electrodes AE.

Specifically, the plurality of light-emitting elements ED2 may be self-assembled to the plurality of concave-convex structures P by applying voltages to the plurality of assembling electrodes AE. For example, an electric field may be formed by applying different alternating current voltages to the plurality of first assembling electrodes AE1 and the plurality of second assembling electrodes AE2. The light-emitting element ED2 may have a polarity by being dielectrically polarized by the electric field. Further, the dielectrically polarized light-emitting element ED2 may be fixed or moved in a particular direction by dielectrophoresis (DEP), i.e., the electric field. Therefore, the plurality of light-emitting elements ED2 may be temporarily self-assembled to the plurality of concave-convex structures P of the assembling substrate 2000 by using the dielectrophoresis.

For example, with reference to FIG. 9D, the plurality of light-emitting elements ED2 include a plurality of red light-emitting elements 220 including the first concave patterns CP1, a plurality of green light-emitting elements 230 including the second concave patterns CP2, and a plurality of blue light-emitting elements 240 including the third concave patterns CP3. In this case, the first concave pattern CP1, the second concave pattern CP2, and the third concave pattern CP3 have different sizes, and the plurality of first concave-convex structures P1, the plurality of second concave-convex structures P2, and the plurality of third concave-convex structures P3 are formed to respectively correspond to the first concave patterns CP1 of the plurality of red light-emitting elements 220, the second concave patterns CP2 of the plurality of green light-emitting elements 230, and the third concave patterns CP3 of the plurality of blue light-emitting elements 240.

Therefore, only the red light-emitting elements 220 are self-assembled to the plurality of first concave-convex structures P1, only the green light-emitting elements 230 are self-assembled to the plurality of second concave-convex structures P2, and only the blue light-emitting elements 240 are self-assembled to the plurality of third concave-convex structures P3.

After the self-assembling is completed, the fluid WT may be evaporated from the assembling substrate 2000. In this case, the light-emitting elements ED2 may be fixed to the plurality of concave-convex structures P by forming an electric field between the assembling electrodes AE until the fluid WT is completely evaporated. Further, the electric field may be removed after the assembling substrate 2000 is completely dried. In this case, even after the electric field is removed, the light-emitting element ED2 may be temporarily fixed to the assembling substrate 2000 by a van der Waals force.

Next, with reference to FIG. 9E, the plurality of light-emitting elements ED2 of the assembling substrate 2000 is transferred to the donor 3000.

First, with reference to FIG. 9E, the assembling substrate 2000 and the donor 3000 are aligned so that the plurality of light-emitting elements ED2 and the donor 3000 face one another. For example, the assembling substrate 2000 and the donor 3000 may be aligned so that a first alignment pattern of the assembling substrate 2000 and a second alignment pattern of the donor 3000 overlap each other.

After the assembling substrate 2000 and the donor 3000 are aligned, the assembling substrate 2000 and the donor 3000 may be joined, such that the upper portion of the light-emitting element ED2 may be in contact with the donor 3000. In this case, the donor 3000 is made of a material having an adhesive force, such that the upper portions of the plurality of light-emitting elements ED2 may be bonded to the donor 3000 and moved to the donor 3000 from the assembling substrate 2000.

Next, with reference to FIG. 9F, the plurality of light-emitting elements ED2 on the donor 3000 are transferred onto the bonding layer AD of the display panel PN.

First, the donor 3000 and the display panel PN formed with the bonding layer AD are aligned. The display panel PN and the donor 3000 may be aligned after the donor 3000 is disposed so that the plurality of light-emitting elements ED2 of the donor 3000 and the bonding layer AD of the display panel PN face one another. An alignment key AK temporarily attached to the donor 3000, is aligned with a third alignment pattern AP3 of the display panel PN when the display panel PN and the donor 3000 are aligned, such that the donor 3000 and the display panel PN may be aligned. The third alignment pattern AP3 may be a pattern disposed in the non-display area NA of the display panel PN. The third alignment pattern AP3 may be made of the same material as any one of the plurality of electrodes or the plurality of lines disposed on the display panel PN. For example, the third alignment pattern AP3 may have a quadrangular shape in which an X-shaped pattern is disposed. Therefore, the donor 3000 and the display panel PN may be aligned so that the alignment key AK is disposed at a center of an X-shaped portion of the third alignment pattern AP3.

Further, with reference to FIGS. 9F and 9G together, the donor 3000 and the display device 1100 may be joined, such that the light-emitting element ED2 on the donor 3000 may be transferred onto the bonding layer AD. The plurality of light-emitting elements ED2 disposed on the donor 3000 is disposed in the arrangement corresponding to the plurality of subpixels SP, such that all the light-emitting elements ED2 on the donor 3000 may be transferred to the display panel PN at once without selectively transferring the light-emitting element ED2. The plurality of light-emitting elements ED2 transferred to the display panel PN may be temporarily fixed by being attached to the bonding layer AD.

Further, the alignment key AK, together with the plurality of light-emitting elements ED2, may be transferred. The alignment key AK may be transferred onto the third alignment pattern AP3 in the non-display area NA. However, because the alignment key AK transferred to the display panel PN is not connected to a separate connection electrode CE, the light is not emitted.

Next, with reference to FIG. 9H, the light-emitting element ED2 is transferred onto the bonding layer AD of the display device 1100, and then the first connection electrode CE1 and the second connection electrode CE2 are formed, such that the light-emitting element ED2 may be electrically connected to the driving transistor DT and the power line VDD.

First, the second planarization layer 1118 and the third planarization layer 1119, which cover the plurality of light-emitting elements ED2, are formed. Further, the contact holes, through which the first electrode 224 and the second electrode 125 of each of the plurality of light-emitting elements ED2 are exposed, may be formed in the third planarization layer 1119. The contact holes, through which the first reflective electrode RE1 and the reflective electrode RE are exposed, may be formed in the third planarization layer 1119, the second planarization layer 1118, and the bonding layer AD.

Next, the first connection electrode CE1 and the second connection electrode CE2 may be formed on the third planarization layer 1119. Further, an electrically conductive material layer may be formed on the front surface of the substrate 110, and the first connection electrode CE1 and the second connection electrode CE2 may be formed by patterning the electrically conductive material layer.

Therefore, in the display device 1100 according to another embodiment of the present disclosure, the first concave-convex structure P1, the second concave-convex structure P2, and the third concave-convex structure P3 of the assembling substrate 2000 are formed to correspond to the first concave pattern CP1 of the red light-emitting element 220, the second concave pattern CP2 of the green light-emitting element 230, and the third concave pattern CP3 of the blue light-emitting element 240. Therefore, the red light-emitting element 220, the green light-emitting element 230, and the blue light-emitting element 240 may be respectively self-assembled to the first concave-convex structure P1, the second concave-convex structure P2, and the third concave-convex structure P3, such that the assembling rate of the light-emitting element ED2 may be improved.

In addition, in the display device 1100 according to another embodiment of the present disclosure, the first concave-convex structure P1, the second concave-convex structure P2, and the third concave-convex structure P3 are disposed to have different sizes, such that only the light-emitting elements ED2 having particular shapes and particular sizes may be self-assembled to the plurality of concave-convex structures P. Therefore, no opening portion may be separately formed in the assembling substrate 2000. Therefore, in the display device 1100 according to another embodiment of the present specification, the process for forming the plurality of opening portions and the organic layer may be excluded.

In addition, in the display device 1100 according to another embodiment of the present disclosure, a process optimization may be implemented because the light-emitting element ED2 may be connected to the display panel without performing the bonding metal forming process and the thermal compression process.

Although the embodiments of the present invention have been described in detail with reference to the accompanying drawings, the present invention is not limited thereto and may be embodied in many different forms without departing from the scope of the present invention. Therefore, the embodiments of the present invention are provided for illustrative purposes only but not intended to limit the scope of the present invention. Therefore, it should be understood that the above-described embodiments are illustrative in all aspects and do not limit the present invention. The scope of the present invention is defined by the following claims.

## Claims

1. A light-emitting element, comprising:
a first semiconductor layer (121) including a concave pattern (CP) that extends from a bottom surface of the first semiconductor layer (121) towards a top surface of the first semiconductor layer (121);
a light-emitting layer (122) on the first semiconductor layer (121);
a second semiconductor layer (123) on the light-emitting layer (122);
a first electrode (124) in contact with the first semiconductor layer (124);
a second electrode (125) in contact with the second semiconductor layer (123); and
an auxiliary electrode (127) between a side surface of the first semiconductor layer (121) and a portion of the first electrode (121),
wherein a first area in which the auxiliary electrode (127) overlaps the side surface of the first semiconductor layer (121) is larger than a second area in which a portion of the first electrode (124) that extends from the bottom surface of the first semiconductor layer (121) overlaps the side surface of the first semiconductor layer (121).

2. The light-emitting element of claim 1, wherein the first electrode (124) is below the first semiconductor layer (121), and/or the first electrode (124) covers a surface of the concave pattern (CP).

3. The light-emitting element of claim 1 or 2, further comprising:
an encapsulation layer (126) that covers a side surface of the first semiconductor layer (121),
wherein a first surface of the encapsulation layer (126) is in direct contact with the side surface of the first semiconductor layer (121), a second surface of the encapsulation layer (126) is in direct contact with the first electrode (124), and the first electrode (124) extends from the bottom surface of the first semiconductor layer (121).

4. The light-emitting element of claim 1, wherein the first electrode (224) is on the first semiconductor layer (121), and an encapsulation layer (226) is disposed to at least partially surround the first semiconductor layer (121) and a reflective layer (227) is disposed below the first semiconductor layer (121) and covers a surface of the concave pattern (CP).

5. A display device (1000), comprising:
a substrate (110) including a plurality of subpixels (SP);
a plurality of transistors (DT) on the substrate (110); and
a light-emitting element (ED1) according to any one of claims 1 to 4 in each of the plurality of subpixels (SP) on the substrate (110),
wherein the light-emitting element (ED1) of at least one of the plurality of subpixels (SP) includes the concave pattern (CP) that extends from a bottom surface of the light-emitting element (ED1) towards a top surface of the light-emitting element (ED1), the bottom surface closer to the substrate (110) than the top surface.

6. The display device of claim 5, further comprising:
a first assembling electrode (AE1) on a first portion of the bottom surface of the light-emitting element (ED1);
a second assembling electrode (AE2) on a second portion of the bottom surface of the light-emitting element (ED1) and spaced apart from the first assembling electrode (AE1); and
a concave-convex structure (P) between the first assembling electrode (AE1) and the second assembling electrode (AE2), wherein the concave-convex structure (P) is in the concave pattern (CP),
preferably further comprising: a first connection electrode connecting the light-emitting element (ED1), the first assembling electrode (AE1), and the second assembling electrode (AE2).

7. The display device of claim 5 or 6, further comprising:
a reflective electrode (227) below the bottom surface of the light-emitting element (ED1); and
a bonding layer (AD) on the bottom surface of the light-emitting element (ED1), the bonding layer (AD) bonded to the light-emitting element (ED1), preferably an interior of the concave pattern (CP) is partially filled with the bonding layer (AD) and/or the concave pattern (CP) includes an airgap.

8. A display device (1100), comprising:
a substrate (110);
a plurality of assembling electrodes (AE) on the substrate (110), the plurality of assembling electrodes (AE) including a plurality of first assembling electrodes (AE1) and a plurality of second assembling electrodes (AE2);
an insulation layer on the plurality of assembling electrodes (AE1, AE2);
a plurality of concave-convex structures (P) on the insulation layer, each of the plurality of concave-convex structures (P) overlapping an area between a first assembling electrode (AE1) of the plurality of first assembling electrodes and a second assembling electrode (AE2) of the plurality of second assembling electrodes, the plurality of concave-convex structures (P) including a first concave-convex structure (P1) of a first size and a second concave-convex structure (P2) of a second size that is different from the first size; and
a plurality of light emitting elements (ED2) according to any one of claims 1 to 4, the plurality of light emitting elements (ED2) including:
a first light emitting element (210) that emits light of a first color and having a first concave pattern (CP1) of a first concave size that extends from a first bottom surface of the first light emitting element (210) towards a first top surface of the first light emitting element (210), the first bottom surface closer to the substrate (110) than the first top surface; and
a second light emitting element (220) that emits light of a second color and having a second concave pattern (CP2) of a second concave size that is different from the first concave size, the second concave pattern (CP2) extending from a second bottom surface of the second light emitting element (220) towards a second top surface of the second light emitting element (220), the second bottom surface closer to the substrate (110) than the second top surface,
wherein the first concave-convex structure (P1) is in the first concave pattern (CP1), and the second concave-convex structure (P2) is in the second concave pattern (CP2).

9. The display device of claim 8, wherein the first size of the first concave-convex structure (P1) includes a first width (W1) and a first height (H1), and the second size of the second concave-convex structure (P2) includes a second width (W2) and a second height (H2), wherein the first width (W1) is less than the second width (W2), and/or the first height (H1) is greater than the second height (H2); and/or
wherein the first concave size of the first concave pattern (CP1) includes a first width and a first height, and the second concave size of the second concave pattern (CP2) includes a second width and a second height, the first width is less than the second width, and the first height is greater than the second height.

10. The display device of claim 8 or 9, wherein the plurality of concave-convex structures (CP) further includes a third concave-convex structure (P3) of a third size that is different from the first size and the second size,
wherein the plurality of light emitting elements further include a third light emitting element (240) that emits light of a third color and having a third concave pattern (CP3) of a third concave size that is different from the first concave size and the second concave size,
wherein the third concave pattern (CP3) extends from a third bottom surface of the third light emitting element (240) towards a third top surface of the third light emitting element (240), the third bottom surface closer to the substrate (110) than the third top surface, and
wherein the third concave-convex structure (P3) is in the third concave pattern (CP3).

## Patentansprüche

1. Lichtemittierendes Element, das umfasst:
eine erste Halbleiterschicht (121), die ein konkaves Muster (CP) enthält, das sich von einer unteren Fläche der ersten Halbleiterschicht (121) in Richtung einer oberen Fläche der ersten Halbleiterschicht (121) erstreckt;
eine lichtemittierende Schicht (122) auf der ersten Halbleiterschicht (121);
eine zweite Halbleiterschicht (123) auf der lichtemittierenden Schicht (122);
eine erste Elektrode (124) in Kontakt mit der ersten Halbleiterschicht (124);
eine zweite Elektrode (125) in Kontakt mit der zweiten Halbleiterschicht (123); und
eine Hilfselektrode (127) zwischen einer Seitenfläche der ersten Halbleiterschicht (121) und einem Abschnitt der ersten Elektrode (121),
wobei ein erster Bereich, in dem die Hilfselektrode (127) die Seitenfläche der ersten Halbleiterschicht (121) überdeckt, größer ist als ein zweiter Bereich, in dem ein Abschnitt der ersten Elektrode (124), der sich von der unteren Fläche der ersten Halbleiterschicht (121) erstreckt, die Seitenfläche der ersten Halbleiterschicht (121) überdeckt.

2. Lichtemittierendes Element nach Anspruch 1, wobei sich die erste Elektrode (124) unter der ersten Halbleiterschicht (121) befindet und/oder die erste Elektrode (124) eine Fläche des konkaven Musters (CP) bedeckt.

3. Lichtemittierendes Element nach Anspruch 1 oder 2, das ferner umfasst:
eine Einkapselungsschicht (126), die eine Seitenfläche der ersten Halbleiterschicht (121) bedeckt,
wobei eine erste Fläche der Einkapselungsschicht (126) in unmittelbarem Kontakt mit der Seitenfläche der ersten Halbleiterschicht (121) ist, eine zweite Fläche der Einkapslungsschicht (126) in unmittelbarem Kontakt mit der ersten Elektrode (124) ist und die erste Elektrode (124) sich von der unteren Fläche der ersten Halbleiterschicht (121) erstreckt.

4. Lichtemittierendes Element nach Anspruch 1, wobei sich die erste Elektrode (224) auf der ersten Halbleiterschicht (121) befindet und eine Einkapselungsschicht (226) so angeordnet ist, dass sie zumindest teilweise die erste Halbleiterschicht (121) umgibt und eine reflektierende Schicht (227) unter der ersten Halbleiterschicht (121) angeordnet ist und eine Fläche des konkaven Musters (CP) bedeckt.

5. Anzeigevorrichtung (1000), die umfasst:
ein Substrat (110), das mehrere Unterpixel (SP) enthält;
mehrere Transistoren (DT) auf dem Substrat (110); und
ein lichtemittierendes Element (ED1) nach einem der Ansprüche 1 bis 4 in jedem der mehreren Unterpixel (SP) auf dem Substrat (110),
wobei das lichtemittierende Element (ED1) mindestens eines der mehreren Unterpixel (SP) das konkave Muster (CP) enthält, das sich von einer unteren Fläche des lichtemittierenden Elements (ED1) in Richtung einer oberen Fläche des lichtemittierenden Elements (ED1) erstreckt, wobei die untere Fläche sich näher als die obere Fläche bei dem Substrat (110) befindet.

6. Anzeigevorrichtung nach Anspruch 5, die ferner umfasst:
eine erste Aufbauelektrode (AE1) auf einem ersten Abschnitt der unteren Fläche des lichtemittierenden Elements (ED1);
eine zweite Aufbauelektrode (AE2) auf einem zweiten Abschnitt der unteren Fläche des lichtemittierenden Elements (ED1) und von der ersten Aufbauelektrode (AE1) beabstandet; und
eine konkav-konvexe Struktur (P) zwischen der ersten Aufbauelektrode (AE1) und der zweiten Aufbauelektrode (AE2), wobei sich die konkav-konvexe Struktur (P) in dem konkaven Muster (CP) befindet, und
die ferner vorzugsweise umfasst: eine erste Verbindungselektrode, die das lichtemittierende Element (ED1), die erste Aufbauelektrode (AE1) und die zweite Aufbauelektrode (AE2) verbindet.

7. Anzeigevorrichtung nach Anspruch 5 oder 6, die ferner umfasst:
eine reflektierende Elektrode (227) unter der unteren Fläche des lichtemittierenden Elements (ED1); und
eine Bindeschicht (AD) auf der unteren Fläche des lichtemittierenden Elements (ED1), wobei die Bindeschicht (AD) an das lichtemittierende Element (ED1) gebunden ist, wobei eine Innenseite des konkaven Musters (CP) vorzugsweise teilweise mit der Bindeschicht (AD) gefüllt ist und/oder das konkave Muster (CP) einen Luftspalt enthält.

8. Anzeigevorrichtung (1100), die umfasst:
ein Substrat (110);
mehrere Aufbauelektroden (AE) auf dem Substrat (110), wobei die mehreren Aufbauelektroden (AE) mehrere erste Aufbauelektroden (AE1) und mehrere zweite Aufbauelektroden (AE2) enthalten;
eine Isolierschicht auf den mehreren Aufbauelektroden (AE1, AE2);
mehrere konkav-konvexe Strukturen (P) auf der Isolierschicht, wobei jede der mehreren konkav-konvexen Strukturen (P) einen Bereich zwischen einer ersten Aufbauelektrode (AE1) der mehreren ersten Aufbauelektroden und einer zweiten Aufbauelektrode (SE2) der mehreren zweiten Aufbauelektroden überdeckt, wobei die mehreren konkav-konvexen Strukturen (P) eine erste konkav-konvexe Struktur (P1) einer ersten Größe und eine zweite konkav-konvexe Struktur (P2) einer zweiten Größe, die von der ersten Größe verschieden ist, enthalten; und
mehrere lichtemittierende Elemente (ED2) nach einem der Ansprüche 1 bis 4, wobei die mehreren lichtemittierenden Elemente (ED2) enthalten:
ein erstes lichtemittierendes Element (210), das Licht einer ersten Farbe emittiert und ein erstes konkaves Muster (CP1) einer ersten konkaven Größe besitzt, das sich von einer ersten unteren Fläche des ersten lichtemittierenden Elements (210) in Richtung einer ersten oberen Fläche des ersten lichtemittierenden Elements (210) erstreckt, wobei sich die erste untere Fläche näher als die erste obere Fläche bei dem Substrat (110) befindet; und
ein zweites lichtemittierendes Element (220), das Licht einer zweiten Farbe emittiert und ein zweites konkaves Muster (CP2) einer zweiten konkaven Größe, die von der ersten konkaven Größe verschieden ist, besitzt, wobei sich das zweite konkave Muster (CP2) von einer zweiten unteren Fläche des zweiten lichtemittierenden Elements (220) in Richtung einer zweiten oberen Fläche des zweiten lichtemittierenden Elements (220) erstreckt, wobei sich die zweite untere Fläche näher als die zweite obere Fläche bei dem Substrat (110) befindet,
wobei die erste konkav-konvexe Struktur (P1) sich in dem ersten konkaven Muster (CP1) befindet und die zweite konkav-konvexe Struktur (P2) sich in dem zweiten konkaven Muster (CP2) befindet.

9. Anzeigevorrichtung nach Anspruch 8, wobei die erste Größe der ersten konkav-konvexen Struktur (P1) eine erste Breite (W1) und eine erste Höhe (H1) aufweist und die zweite Größe der zweiten konkav-konvexen Struktur (P2) eine zweite Breite (W2) und eine zweite Höhe (H2) aufweist, wobei die erste Breite (W1) kleiner als die zweite Breite (W2) ist und/oder die erste Höhe (H1) größer als die zweite Höhe (H2) ist; und/oder
wobei die erste konkave Größe des ersten konkaven Musters (CP1) eine erste Breite und eine erste Höhe aufweist und die zweite konkave Größe des zweiten konkaven Musters (CP2) eine zweite Breite und eine zweite Höhe aufweist, wobei die erste Breite kleiner als die zweite Breite ist und die erste Höhe größer als die zweite Höhe ist.

10. Anzeigevorrichtung nach Anspruch 8 oder 9, wobei die mehreren konkav-konvexen Strukturen (CP) ferner eine dritte konkav-konvexe Struktur (P3) einer dritten Größe, die von der ersten Größe und der zweiten Größe verschieden ist, umfassen,
wobei die mehreren lichtemittierenden Elemente ferner ein drittes lichtemittierendes Element (240), das Licht einer dritten Farbe emittiert und ein drittes konkaves Muster (CP3) einer dritten konkaven Größe, die von der ersten konkaven Größe und der zweiten konkaven Größe verschieden ist, besitzt, umfassen,
wobei sich das dritte konkave Muster (CP3) von einer dritten unteren Fläche des dritten lichtemittierenden Elements (240) in Richtung einer dritten oberen Fläche des dritten lichtemittierenden Elements (240) erstreckt, wobei sich die dritte untere Fläche näher als die dritte obere Fläche bei dem Substrat (110) befindet, und
wobei sich die dritte konkav-konvexe Struktur (P3) in dem dritten konkaven Muster (CP3) befindet.

## Revendications

1. Élément électroluminescent, comportant :
une première couche semi-conductrice (121) incluant un motif concave (CP) qui s'étend à partir d'une surface inférieure de la première couche semi-conductrice (121) vers une surface supérieure de la première couche semi-conductrice (121) ;
une couche électroluminescente (122) sur la première couche semi-conductrice (121) ;
une seconde couche semi-conductrice (123) sur la couche électroluminescente (122) ;
une première électrode (124) en contact avec la première couche semi-conductrice (124);
une seconde électrode (125) en contact avec la seconde couche semi-conductrice (123) ; et
une électrode auxiliaire (127) entre une surface latérale de la première couche semi-conductrice (121) et une partie de la première électrode (121),
dans lequel une première zone dans laquelle l'électrode auxiliaire (127) chevauche la surface latérale de la première couche semi-conductrice (121) est plus grande qu'une seconde zone dans laquelle une partie de la première électrode (124) qui s'étend à partir de la surface inférieure de la première couche semi-conductrice (121) chevauche la surface latérale de la première couche semi-conductrice (121).

2. Élément électroluminescent selon la revendication 1, dans lequel la première électrode (124) est au-dessous de la première couche semi-conductrice (121) et/ou la première électrode (124) recouvre une surface du motif concave (CP).

3. Élément électroluminescent selon la revendication 1 ou 2, comportant en outre :
une couche d'encapsulation (126) qui recouvre une surface latérale de la première couche semi-conductrice (121),
dans lequel une première surface de la couche d'encapsulation (126) est en contact direct avec la surface latérale de la première couche semi-conductrice (121), une seconde surface de la couche d'encapsulation (126) est en contact direct avec la première électrode (124), et la première électrode (124) s'étend à partir de la surface inférieure de la première couche semi-conductrice (121).

4. Élément électroluminescent selon la revendication 1, dans lequel la première électrode (224) est sur la première couche semi-conductrice (121), et une couche d'encapsulation (226) est disposée de manière à entourer au moins partiellement la première couche semi-conductrice (121) et une couche réfléchissante (227) est disposée sous la première couche semi-conductrice (121) et recouvre une surface du motif concave (CP).

5. Dispositif d'affichage (1000), comportant :
un substrat (110) incluant une pluralité de sous-pixels (SP) ;
une pluralité de transistors (DT) sur le substrat (110) ; et
un élément électroluminescent (ED1) selon l'une quelconque des revendications 1 à 4 dans chaque sous-pixel de la pluralité de sous-pixels (SP) sur le substrat (110),
dans lequel l'élément électroluminescent (ED1) d'au moins un sous-pixel de la pluralité de sous-pixels (SP) inclut le motif concave (CP) qui s'étend à partir d'une surface inférieure de l'élément électroluminescent (ED1) vers une surface supérieure de l'élément électroluminescent (ED1), la surface inférieure étant plus près du substrat (110) que la surface supérieure.

6. Dispositif d'affichage selon la revendication 5, comportant en outre :
une première électrode d'assemblage (AE1) sur une première partie de la surface inférieure de l'élément électroluminescent (ED1) ;
une seconde électrode d'assemblage (AE2) sur une seconde partie de la surface inférieure de l'élément électroluminescent (ED1) et espacée de la première électrode d'assemblage (AE1) ; et
une structure concave-convexe (P) entre la première électrode d'assemblage (AE1) et la seconde électrode d'assemblage (AE2), dans lequel la structure concave-convexe (P) est dans le motif concave (CP),
de préférence, comportant en outre : une première électrode de connexion connectant l'élément électroluminescent (ED1), la première électrode d'assemblage (AE1) et la seconde électrode d'assemblage (AE2).

7. Dispositif d'affichage selon la revendication 5 ou 6, comportant en outre :
une électrode réfléchissante (227) sous la surface inférieure de l'élément électroluminescent (ED1) ; et
une couche de liaison (AD) sur la surface inférieure de l'élément électroluminescent (ED1), la couche de liaison (AD) étant liée à l'élément électroluminescent (ED1), un intérieur du motif concave (CP) étant de préférence partiellement rempli de la couche de liaison (AD) et/ou le motif concave (CP) inclut un intervalle d'air.

8. Dispositif d'affichage (1100), comportant :
un substrat (110) ;
une pluralité d'électrodes d'assemblage (AE) sur le substrat (110), la pluralité d'électrodes d'assemblage (AE) incluant une pluralité de premières électrodes d'assemblage (AE1) et une pluralité de secondes électrodes d'assemblage (AE2) ;
une couche d'isolation sur la pluralité d'électrodes d'assemblage (AE1, AE2) ;
une pluralité de structures concaves-convexes (P) sur la couche d'isolation, chaque structure de la pluralité de structures concaves-convexes (P) chevauchant une zone entre une première électrode d'assemblage (AE1) de la pluralité de premières électrodes d'assemblage et une seconde électrode d'assemblage (AE2) de la pluralité de secondes électrodes d'assemblage, la pluralité de structures concaves-convexes (P) incluant une première structure concave-convexe (P1) d'une première taille et une deuxième structure concave-convexe (P2) d'une deuxième taille qui est différente de la première taille ; et
une pluralité d'éléments électroluminescents (ED2) selon l'une quelconque des revendications 1 à 4, la pluralité d'éléments électroluminescents (ED2) comportant :
un premier élément électroluminescent (210) qui émet de la lumière d'une première couleur et ayant un premier motif concave (CP1) d'une première taille concave qui s'étend à partir d'une première surface inférieure du premier élément électroluminescent (210) vers une première surface supérieure du premier élément électroluminescent (210), la première surface inférieure étant plus près du substrat (110) que la première surface supérieure ; et
un deuxième élément électroluminescent (220) qui émet de la lumière d'une deuxième couleur et ayant un deuxième motif concave (CP2) d'une deuxième taille concave qui est différente de la première taille concave, le deuxième motif concave (CP2) s'étendant à partir d'une seconde surface inférieure du second élément électroluminescent (220) vers une seconde surface supérieure du second élément électroluminescent (220), la seconde surface inférieure étant plus près du substrat (110) que la seconde surface supérieure,
dans lequel la première structure concave-convexe (P1) est dans le premier motif concave (CP1), et la seconde structure concave-convexe (P2) est dans le second motif concave (CP2).

9. Dispositif d'affichage selon la revendication 8, dans lequel la première taille de la première structure concave-convexe (P1) inclut une première largeur (W1) et une première hauteur (H1), et la seconde taille de la seconde structure concave-convexe (P2) inclut une seconde largeur (W2) et une seconde hauteur (H2), dans lequel la première largeur (W1) est inférieure à la seconde largeur (W2), et/ou la première hauteur (H1) est supérieure à la seconde hauteur (H2) ; et/ou
dans lequel la première taille concave du premier motif concave (CP1) inclut une première largeur et une première hauteur, et la seconde taille concave du second motif concave (CP2) inclut une seconde largeur et une seconde hauteur, la première largeur est inférieure à la seconde largeur, et la première hauteur est supérieure à la seconde hauteur.

10. Dispositif d'affichage selon la revendication 8 ou 9, dans lequel la pluralité de structures concaves-convexes (CP) inclut en outre une troisième structure concave-convexe (P3) d'une troisième taille qui est différente de la première taille et de la deuxième taille,
dans lequel les éléments de la pluralité d'éléments électroluminescents incluent en outre un troisième élément électroluminescent (240) qui émet de la lumière d'une troisième couleur et ayant un troisième motif concave (CP3) d'une troisième taille concave qui est différente de la première taille concave et de la deuxième taille concave,
dans lequel le troisième motif concave (CP3) s'étend à partir d'une troisième surface inférieure du troisième élément électroluminescent (240) vers une troisième surface supérieure du troisième élément électroluminescent (240), la troisième surface inférieure étant plus près du substrat (110) que la troisième surface supérieure, et
dans lequel la troisième structure concave-convexe (P3) est dans le troisième motif concave (CP3).
